(19) Europäisches Patentamt / European Patent Office / Office européen des brevets

(11) **EP 1 618 426 B1**

(12) **EUROPÄISCHE PATENTSCHRIFT**

(45) Veröffentlichungstag und Bekanntmachung des Hinweises auf die Patenterteilung:
**02.03.2011 Patentblatt 2011/09**

(51) Int Cl.:
**G02B 21/24** (2006.01)  **G02B 7/32** (2006.01)
**G03F 9/00** (2006.01)  **G03F 7/20** (2006.01)

(21) Anmeldenummer: **04729615.7**

(22) Anmeldetag: **27.04.2004**

(86) Internationale Anmeldenummer:
**PCT/EP2004/004427**

(87) Internationale Veröffentlichungsnummer:
**WO 2004/097493 (11.11.2004 Gazette 2004/46)**

(54) **VERFAHREN UND ANORDNUNG ZUR BESTIMMUNG DER FOKUSPOSITION BEI DER ABBILDUNG EINER PROBE**

METHOD AND ARRAY FOR DETERMINING THE FOCAL POSITION DURING IMAGING OF A SAMPLE

PROCEDE ET DISPOSITIF POUR DETERMINER LA POSITION DU POINT FOCAL LORS DE L'OBTENTION D'UNE IMAGE D'UN ECHANTILLON

(84) Benannte Vertragsstaaten:
**AT BE BG CH CY CZ DE DK EE ES FI FR GB GR HU IE IT LI LU MC NL PL PT RO SE SI SK TR**

(30) Priorität: **29.04.2003 DE 10319182**

(43) Veröffentlichungstag der Anmeldung:
**25.01.2006 Patentblatt 2006/04**

(73) Patentinhaber: **Carl Zeiss MicroImaging GmbH**
**Carl-Zeiss-Promenade 10**
**07745 Jena (DE)**

(72) Erfinder:
• **BUBLITZ, Daniel**
**07743 Jena (DE)**
• **GRÄFE, Dieter**
**07745 Jena (DE)**

• **WESTPHAL, Peter**
**07743 Jena (DE)**

(74) Vertreter: **Geyer, Fehners & Partner**
**Patentanwälte**
**Sellierstrasse 1**
**07745 Jena (DE)**

(56) Entgegenhaltungen:
**US-A- 2 524 807     US-A- 5 633 721**
**US-A- 5 867 604     US-A- 5 991 004**
**US-B1- 6 353 478**

• **PATENT ABSTRACTS OF JAPAN Bd. 1999, Nr. 12, 29. Oktober 1999 (1999-10-29) -& JP 11 183154 A (HITACHI LTD), 9. Juli 1999 (1999-07-09)**

**Beschreibung**

Die Erfindung bezieht sich auf ein Verfahren zur Bestimmung der Fokusposition bei der Abbildung einer Probe, bei dem eine Feldblende auf die Probe abgebildet wird, diese Abbildung mittels einer relativ zur Feldblende geneigten posititonsempfindlichen Empfangseinrichtung detektiert wird und die Fokusposition anhand der Intensitätsverteilung auf der Empfangseinrichtung bestimmt wird. Die Erfindung bezieht sich weiterhin auf Anordnungen zur Durchführung des erfindungsgemäßen Verfahrens.

Um mittels einer Abbildungsoptik präzise Abbildungen einer Probe bzw. eines Probenabschnitts zu erhalten, ist es erforderlich, die Probe exakt in die Fokusposition der Abbildungsoptik zu stellen. Ist die Abbildung unscharf, ist es wichtig zu erfahren, um welchen Betrag und in welcher Richtung eine Lageveränderung der Probe relativ zur Abbildungsoptik zu veranlassen ist und ggf. entsprechende Stellbefehle abzuleiten, die zu einer Nachfokussierung genutzt werden können.

In diesem Zusammenhang sind im wesentlichen Triangulationsverfahren, abbildende Verfahren mit Kontrastauswertung und die Positionsbestimmung mittels schräg gestellter konfokaler Spaltblende bekannt.

Bei den Triangulationsverfahren wird ein kollimierter Laserstrahl in die Pupillenebene eines Abbildungsobjektivs eingespiegelt und aus dem Verlauf dieses Laserstrahls relativ zum Abbildungsstrahlengang auf die Z-Position des von der Probe reflektierten Laserlichts geschlossen.

Ein wesentlicher Nachteil dieser Verfahrensweise besteht darin, daß durch die Abbildung des Laserlichts in unterschiedlich tief gelegene Ebenen der Probe Bildfehler auftreten und dadurch das detektierte Signal über einen gegebenen Tiefenschärfebereich stark variiert.

Die Genauigkeit bei der Bestimmung der Fokusposition ist nachteiligerweise davon abhängig, ob das Meßergebnis vom Zentrum oder an der Peripherie des Fangbereiches eines Detektors ermittelt wird. Um diesen Effekt zu kompensieren, muß die Fokusposition in mehreren iterativen Schritten bestimmt werden, was dazu führt, daß diese Verfahrensweise verhältnismäßig viel Zeit erfordert.

Bei abbildenden Verfahren mit Kontrastauswertung wird die Probe mit einer gitterförmigen Intensitätsverteilung beleuchtet, indem in die Feldblendenebene des Beleuchtungsstrahlengangs ein Gitter gestellt wird. Die so beleuchtete Probe wird auf eine Empfangseinrichtung abgebildet. Auf diese Weise wird eine Serie von Bildern mit unterschiedlichen Abständen zwischen der Abbildungsoptik und der Probe aufgenommen und aus dieser Serie das Bild mit dem höchsten Kontrast bestimmt. Der Abstand zwischen Abbildungsoptik und Probe, der diesem Bild zugeordnet ist, gilt als optimaler Fokusabstand.

Der Nachteil besteht darin, daß zur Aufnahme der Bildserie viele verschiedene Z-Positionen mit hoher Genauigkeit angefahren werden müssen, wodurch auch für diese Verfahrensweise verhältnismäßig viel Zeit erforderlich ist.

Bei der Positionsbestimmung mittels schräg gestellter konfokaler Spaltblende wird in die Feldblendenebene des Beleuchtungsstrahlengangs eine Spaltblende gestellt und auf die Probe abgebildet. Das dabei von der Probe reflektierte Licht wird auf eine relativ zur Spaltblende geneigt angeordnete CCD-Zeile gerichtet, und es wird die Position auf der CCD-Zeile bestimmt, an dem das reflektierte Licht ein Maximum hat. Da bei dieser Verfahrensweise die Fokusposition mit einer einzigen Abbildung auf die Zeile berechnet werden kann, liegt das Ergebnis der Fokusbestimmung in verhältnismäßig kurzer Zeit vor.

Nachteile bestehen allerdings insofern, als Verunreinigungen auf der Probe oder störende Strukturen auf der Probenoberfläche Intensitätsschwankungen verursachen, die zu fehlerhaften Meßergebnissen führen können. Das Hauptproblem bei dieser Verfahrensweise ist der sehr hohe Justieraufwand bei der Abbildung des Spaltes auf die CCD-Zeile, denn die Spalte (oder die Zeile) muß sehr schmal sein, um eine hohe Genauigkeit erreichen zu können. Außerdem ist eine sehr gut korrigierte Abbildungsoptik erforderlich.

Insbesondere bei der Chipherstellung werden immer feinere Strukturen und dünnere Schichten angestrebt, was dazu führt, daß auch die Anforderungen an die Inspektionsverfahren, mit denen die Herstellungsgenauigkeit überprüft wird, immer höher werden. Dementsprechend wird eine immer schnellere und genauere Fokussierung möglichst ohne Unterbrechung des Fertigungsablaufs gefordert.

Davon ausgehend liegt der Erfindung die Aufgabe zugrunde, die Genauigkeit bei der Bestimmung der Fokusposition weiter zu erhöhen und auch Anordnungen anzugeben, welche die Ausführung eines solchen genaueren Verfahrens ermöglichen.

Die vorliegende Erfindung ist dem Sachgebiet der Positionsbestimmung mittels schräg gestellter Spaltblende zuzuordnen.

Erfindungsgemäß werden bei einem Verfahren der eingangs genannten Art, bei dem eine Feldblende auf die Probe abgebildet und diese Abbildung zumindest teilweise durch die Abbildung eines optischen Gitters überlagert wird, mittels einer relativ zur Feldblende geneigten positionsempfindlichen Empfangseinrichtung Intensitätswerte für das von der Probe reflektierte Licht gewonnen. Diese Intensitätswerte werden Positionen auf der Empfangseinrichtung zugeordnet. Aus den positionsbezogenen Intensitätswerten werden positionsbezogene Kontrastwerte ermittelt und anhand dieser Kontrastwerte wird die Position des Kontrastschwerpunktes auf der Empfangseinrichtung als ein Äquivalent für die aktuelle Fokusposition bestimmt.

Im Unterschied zu den einschlägigen Verfahren nach dem Stand der Technik wird die Fokusposition nicht als Äquivalent des Intentsitätsmaximums auf der Empfangseinrichtung gewonnen, sondern die Überlagerung der Blendenabbildung auf der Probe mit der Abbildung eines optischen Gitters macht es möglich, positionsbezogene Kontrastwerten zu ermitteln und diese der Bestimmung der aktuellen Fokusposition zugrunde zu legen.

Dies hat gegenüber dem bisher bekannten Verfahren den wesentlichen Vorteil, daß der Justieraufwand bedeutend reduziert ist. Außerdem sind die Ergebnisse bei der Bestimmung der Fokusposition nicht mehr so sehr durch Untergrundlicht, Verunreinigungen auf der Probe oder störende Probenstrukturen verfälscht. Insofern ist mit der Erfindung ein schnelles Verfahren geschaffen, das im Vergleich zum Stand der Technik eine wesentlich höhere Genauigkeit gewährleistet.

In einer bevorzugten Ausgestaltungsvariante des erfindungsgemäßen Verfahrens ist vorgesehen, daß positionsbezogene Kontrastwerte $I(y_i)$ nach der Funktion

$$\forall i \quad I(y_i) := \left| I(x_i) - I(x_{i+n}) \right|$$

ermittelt werden. Hierin bedeuten $I(x_i)$ Intensitätswerte, die einer Position $x_i$ auf der Empfangseinrichtung zugeordnet sind, während $I(x_{i+n})$ Intensitätswerte sind, die einer benachbarten Position $x_{i+n}$ zugeordnet sind. Dabei wird n bevorzugt im Bereich von 1...20 gewählt.

Anschließend an die Ermittlung der positionsbezogenen Kontrastwerte wird als ein Äquivalent für die aktuelle Fokusposition $P_f$ ein Ort ermittelt nach der Funktion

$$P_f := \frac{\sum_i y_i \cdot I(y_i)}{\sum_i I(y_i)}$$

Hier werden alle die Kontrastwerte $I(y_i)$ einbezogen, die größer sind als ein vorbestimmter Mindestwert $I_{min}$.

Damit wird in vielen Anwendungsfällen bereits eine im Vergleich zum Stand der Technik hohe Genauigkeit bei verringertem Justageaufwand erzielt.

Für noch höhere Anforderungen an die Genauigkeit wird zunächst in einem ersten Schritt ein Ort $P_f'$ ermittelt nach der Funktion

$$P_f' := \frac{\sum_i y_i \cdot I(y_i)}{\sum_i I(y_i)}$$

für alle Kontrastwerte $I(y_i)$, die größer sind als ein vorbestimmter Mindestwert $I_{min}$, und hieran anschließend

in einem zweiten Schritt als das Äquivalent für die aktuelle Fokusposition $P_f$ ein Ort ermittelt nach der Funktion

$$P_f := \frac{\sum_i y_i \cdot I(y_i)}{\sum_i I(y_i)}$$

für alle Kontrastwerte $I(y_i)$, die größer sind als ein Mindestwert $I'_{min}$ und die nicht weiter von dem Ort $P_f'$ entfernt sind als um einen vorgegebenen Abstand a.

Dabei können die für den ersten Schritt und für den zweiten Schritt jeweils festgelegten Mindestwerte $I_{min}$ bzw. $I'_{min}$ gleich groß oder auch verschieden groß sein.

Bevorzugt wird als Blende eine Spaltblende genutzt, als optisches Gitter ein Absorptionsgitter in Form einer streifenförmigen Maske und als Empfangseinrichtung eine CCD-Zeile. Die Positionen $x_i$ sind in diesem Falle charakterisiert durch die fortlaufende Numerierung der Sensorelemente auf der CCD-Zeile, im Folgenden als Pixel bezeichnet. Hat die CCD-Zeile beispielsweise 2400 Pixel, sind deren Positionen mit $x_i$ bis $x_{2400}$ definiert. Der Abstand a zwischen zwei Pixeln auf der CCD-Zeile wird dann mit einer Anzahl Pixel angegeben, wobei a bevorzugt im Bereich von 10 bis 1000 vorgegeben wird.

In einer weiterführenden Ausgestaltung, die insbesondere bei der automatischen Fertigungskontrolle Anwendung finden kann, wird aus dem auf der Empfangseinrichtung gemessenen Abstand b zwischen einem Ort auf der Empfangseinrichtung, welcher der idealen Fokusposition $P_f''$ auf der Empfangseinrichtung entspricht, und dem Ort, welcher der aktuellen Fokusposition $P_f$ entspricht, ein Stellsignal zur automatischen Fokussierung generiert.

Dabei wird das Stellsignal bevorzugt zur Änderung des Abstandes $\Delta z$ zwischen der Probe und der Abbildungsoptik genutzt, bis sich die auf die CCD-Zeile abgebildeten Orte $P_f$ mit dem anhand einer Gerätekalibrierung vorgegebenen Ort $P_f''$ decken.

Derartige Stelleinrichtungen sind aus dem Stand der Technik bekannt und müssen deshalb hier nicht näher erläutert werden. Als Antriebe für solche Stelleinrichtungen haben sich insbesondere Schrittmotoren bewährt, die an einen Probentisch gekoppelt sind.

Eine weitere Ausgestaltung der Erfindung ist nicht nur dazu geeignet, die aktuelle Fokusposition zu bestimmen, sondern dient auch zur Ermittlung einer Verkippung der Fokusebene in Bezug auf die Empfangsfläche eines Detektors in der Empfangseinrichtung.

Diesbezüglich ist vorgesehen, daß als Blende eine Rechteckblende und als Empfangseinrichtung eine CCD-Matrix verwendet werden und das optische Gitter aus zwei in der Gitterebene gegeneinander geneigten Gittermasken besteht, von denen jede mehrere parallel zueinander verlaufende streifenförmige Masken aufweist. Dabei ist vorgesehen, daß von jeder der streifenförmigen Masken eine Abbildung auf der Probe erzeugt wird und mittels der CCD-Matrix für jede abgebildete Maske die Position des Kontrastschwerpunktes nach der Verfahrensweise bestimmt wird, wie sie weiter oben bzw. auch in den Ansprüchen 2 bis 4 beschrieben ist.

In diesem Falle sind die Positionen des Kontrastschwerpunktes auf jeder abgebildeten Maske das Äquivalent einer aktuelle Fokusposition. Erfindungsgemäß werden der Verlauf und die Neigung der beiden Verbindungsgeraden durch die Kontrastschwerpunkte und daraus der Verkippungswinkel der Fokusebene in Bezug auf die Empfangsfläche der CCD-Matrix bestimmt, wie dies weiter unten noch näher erläutert wird.

Auch hier ist es denkbar, daß aus dem so ermittelten Verkippungswinkel der Fokusebene in Bezug auf die Ebene der Empfangsfläche der CCD-Matrix ein Stellsignal gewonnen und dieses über eine Stelleinrichtung, welche die Neigung der Probe relativ zur optischen Achse des Abbildungsstrahlengangs beeinflußt, zur Kompensation des Verkippungswinkels genutzt wird.

Bei jeder der vorgenannten Ausführungsvarianten der Erfindung wird die Spaltbreite der optischen Gitter in Abhängigkeit vom Reflektionsvermögen eines ausgewählten Probenabschnitts und/oder von der Intensität von gestreutem oder reflektiertem und deshalb störendem Licht vorgegeben. Zur Erhöhung der Genauigkeit bei der Bestimmung des Kontrastschwerpunktes sollte die Spaltbreite um so kleiner vorgegeben werden, je geringer das Reflektionsvermögen des Probenabschnitts oder je intensiver störendes gestreutes oder reflektiertes Licht ist.

Weiterhin erweist es sich unter Umständen als vorteilhaft, zur Weiterverarbeitung der Intensitätswerte zu positionsbezogenen Kontrastwerten zunächst die Intensitätswerte benachbarter Pixel über eine Periode des abgebildeten Gitters zu mitteln, dann die Abweichungen des dabei gewonnenen Intensitätssignals $I_{ist}$ von einem vorgegebenen Intensitätssignal $I_{soll}$ zu bestimmen und schließlich in Abhängigkeit von der sich dabei ergebenden Differenz eine Korrektur der Kontrastwerte vorzunehmen.

Hierdurch muß vorteilhaft zunächst nur ein Intensitätswert, nämlich das gemittelte Intensitätssignal $I_{ist}$ bestimmt werden. Unter Zugrundelegung der Abweichung dieses Intensitätssignals $I_{ist}$ von einem zu erwartenden Intensitätssignal $I_{soll}$ werden dann die Kontrastwerte so korrigiert, daß Störungen, die durch Schmutzpartikel im optischen Strahlengang oder durch eine nicht gleichmäßig reflektierende Probe verursacht werden, kompensiert sind.

Dabei kann die Mittelung der Intensitätswerte benachbarter Pixel vorgenommen werden nach der Funktion

$$I(x_i) := \frac{1}{n} \sum_{j=0}^{n} J\left(x_{i+j-\frac{n}{2}}\right)$$

für alle $x_i$ mit n=2 ... 100, wobei bevorzugt n der Anzahl der Pixel je Gitterperiode entspricht.

Die Erfindung bezieht sich weiterhin auf eine Anordnung zur Durchführung der bisher beschriebenen Verfahrensschritte, die insbesondere als Mikroskopanordnung ausgebildet sein kann, umfassend: eine Lichtquelle zur Erzeugung eines Beleuchtungsstrahlengangs, eine Abbildungsoptik, durch die der Beleuchtungsstrahlengang auf die Probe gerichtet ist und eine im Abbildungsstrahlengang angeordnete Kamera, wobei

- in den Beleuchtungsstrahlengang eine durch eine Gittermaske überlagerte Spaltöffnung gestellt ist,
- ein aus dem Abbildungsstrahlengang abgezweigter Detektionsstrahlengang auf eine CCD-Zeile gerichtet ist,
- die CCD-Zeile mit der optischen Achse des Detektionsstrahlengangs einen Winkel α#90° einschließt,
- die CCD-Zeile mit einer Auswerteeinrichtung zur Ermittlung von positionsbezogenen Intensitätswerten $I(x_i)$ und von positionsbezogenen Kontrastwerten $I(y_i)$ in Verbindung steht, und
- die Auswerteeinrichtung zur Ermittlung der Position des Kontrastschwerpunktes auf der CCD-Zeile als ein Äquivalent für die aktuelle Fokusposition ausgebildet ist.

Vorteilhaft ist die Spaltöffnung gemeinsam mit einer Blendenöffnung, die den Umfang und die Größe eines Bildausschnitts auf der Probe definiert, in der Feldblendenebene der Anordnung positioniert, wobei die Blendenöffnung zentrisch zur optischen Achse des Beleuchtungsstrahlengangs ausgerichtet ist und sich die Spaltöffnung an der Peripherie des Beleuchtungsstrahlengangs befindet.

Bei einer Ausgestaltungsvariante der erfindungsgemäßen Anordnung, die insbesondere zur Beobachtung und Untersuchung von Proben mit stark streuenden Oberflächen geeignet ist, sollte die Blendenöffnung senkrecht zur optischen Achse des Beleuchtungsstrahlengangs ausgerichtet sein, während die Spaltöffnung mit der optischen Achse einen Winkel einschließt, der dem Winkel entspricht, um den die CCD-Zeile gegen die optische Achse des Detektionsstrahlengangs geneigt ist, wobei die optische Weglänge zwischen der Probe und der Spaltöffnung ebenso groß ist wie die optische Weglänge zwischen der Probe und der CCD-Zeile.

Dabei kann die Auswerteeinrichtung beispielsweise einen Differenzbildner umfassen, der positionsbezogene Kontrastwerte $I(y_i)$ nach der Funktion

$$\forall i \quad I(y_i) := \left| I(x_i) - I(x_{i+n}) \right|$$

ermittelt, mit jeweils den Intensitätswerten $I(x_i)$ und $I(x_{i+n})$, die den Positionen $x_i$ und $x_{i+n}$ zugeordnet sind, und wobei die Auswerteeinrichtung weiterhin ausgestattet ist mit einer Rechenschaltung, die den Kontrastschwerpunkt als Äquivalent für die aktuelle Fokusposition ermittelt nach der Funktion

$$P_f := \frac{\sum_i y_i \cdot I(y_i)}{\sum_i I(y_i)}$$

für alle Kontrastwerte $I(y_i)$, die größer sind als ein vorbestimmter Mindestwert $I_{min}$.

Dabei bestimmt der Wert n den Abstand benachbarter Positionen auf der CCD-Zeile zueinander. Insofern ist n variabel und wird je nach Anwendung vorgegeben mit n = 1...20.

Insbesondere für die Anwendung im Zusammenhang mit Einrichtungen zur automatischen Biochip-Fertigung, bei denen auch die Kontrolle der Fertigungsgenauigkeit selbständig abläuft, ist in der Auswerteeinrichtung eine Rechenschaltung vorgesehen, die zur Ermittlung des Abstandes b ausgebildet ist zwischen dem Ort, welcher der aktuellen Fokusposition $P_f$ auf der CCD-Zeile entspricht, und einem Ort, welcher der idealen Fokusposition $P_f''$ auf der CCD-Zeile entspricht. Damit erhält man ein Maß für die Abweichung von der idealen Fokusposition.

Demzufolge ist es weiterhin von Vorteil, wenn die Auswerteeinrichtung so konfiguriert ist, daß sie aus der Abweichung von der idealen Fokusposition ein Stellsignal ermittelt und mit einer Stelleinrichtung zur Korrektur der Fokusposition in Verbindung steht, die beispielsweise eine Änderung des Abstandes $\Delta z$ zwischen der Probe und der Abbildungsoptik bewirkt. Damit kann der Abstand zwischen der aktuellen Fokusposition und der idealen Fokusposition beeinflußt werden, wobei die Verstellung so lange und so oft vorgenommen wird, bis der Abstand b gegen 0 geht und damit die ideale Fokusposition eingestellt ist.

Um optimale Ergebnisse bei der Bestimmung der aktuellen Fokusposition sowie bei der Ermittlung der Ablage zur idealen Fokusposition erzielen zu können, ist es vorteilhaft, wenn die Frequenz des jeweils zur Abbildung auf die Probe genutzten Gitters der optischen Auflösungsgrenze der Abbildungsoptik angepaßt ist. Bevorzugt sollten dabei jeweils fünf Pixel der CCD-Zeile einer Gitter-Periode entsprechen.

Bei der Abbildung ebener Probenoberflächen kann das erfindungsgemäße Verfahren bzw. die bisher beschriebene Anordnung auch zu Nivellierzwecken genutzt werden, indem die Neigung der Probenoberfläche relativ zur optischen Achse des Objektivstrahlengangs ermittelt und auf einen vorgegebenen Wert, bevorzugt auf einen Winkel von 90° zur optischen Achse, korrigiert wird.

Zu diesem Zweck ist die Anordnung mit einem Probentisch auszustatten, der in den Koordinatenrichtungen X und Y senkrecht zur optischen Achse verschiebbar ist. Damit ist es möglich, auf drei verschiedene Punkte der Probenoberfläche zu fokussieren, die nicht auf einer Geraden liegen. Für jeden dieser drei Punkte wird die aktuelle Fokusposition auf der CCD-Zeile ermittelt und jeweils die Ablage von der idealen Fokusposition und/oder der Fokusabstand bestimmt.

Aus der goemetrischen Verknüpfung der Ablagen bzw. der Fokusabstände wird die Neigung der Probenoberfläche gegenüber der optischen Achse des Objektivstrahlengangs errechnet und/oder durch Verkippung der Probe mittels einer Stelleinrichtung die Neigung der Probenoberfläche so verändert, daß die Ablagen zwischen aktueller und idealer Fokusposition bzw. die Fokusabstände für alle drei Punkte gleich groß sind und damit die Probenoberfläche senkrecht zur optischen Achse des Objektivstrahlengangs ausgerichtet ist.

Die Stelleinrichtung, die beispielsweise als Drei-Punkt-Linearverstellung oder Zwei-Achsen-Drehverstellung ausgeführt sein kann, wird in Abhängigkeit von der aktuellen Neigung und einem daraus zu generierenden Stellbefehl angesteuert, bis die unerwünschte Neigung korrigiert ist.

Die Erfindung soll nachfolgend anhand von Ausführungsbeispielen erläutert werden. In den zugehörigen Zeichnungen zeigen :

| | |
|---|---|
| Fig.1 | das Grundprinzip einer Anordnung zur Durchführung des erfindungsgemäßen Verfahrens, |
| Fig.2 | eine Einzelheit aus Fig.1, die Blendenanordnung in der Feldblendenebene betreffend, |
| Fig.3 | die symbolische Darstellung einer als Empfangsein- richtung genutzten CCD-Zeile, |
| Fig.4 | einen beispielhaft sich über die CCD-Zeile hinweg ergebenden Intensitätsverlauf, |
| Fig.5 | den sich in Abhängigkeit vom Intensitätsverlauf aus Fig.4 ergebenden Verlauf von Kontrastwerten, |
| Fig.6 | die Ausstattung der erfindungsgemäßen Anordnung mit einer Auswerteeinrichtung und einer Zustelleinrich- tung für eine automatische Fokussierung, |
| Fig.7 | den typischen Intensitätsverlauf bei der Abbildung einer Gläs-/Wasser-Grenzfläche auf die CCD-Zeile, |
| Fig.8 | den sich in Abhängigkeit vom Intensitätsverlauf aus Fig.7 ergebenden Verlauf von Kontrastwerten, |
| Fig.9 | die Ausführung der erfindungsgemäßen Anordnung mit geneigter Empfangseinrichtung und geneigter Spalt- öffnung, |
| Fig.10 | eine Variante der erfindungsgemäßen Anordnung, bei der neben der genauen Bestimmung der Fokusposition auch eine Aussage zur Verkippung der Probenebene relativ zur Empfangsfläche in der Empfangseinrich- tung getroffen wird, |
| Fig.11 | eine vergrößerte Darstellung einer Blendenan- |

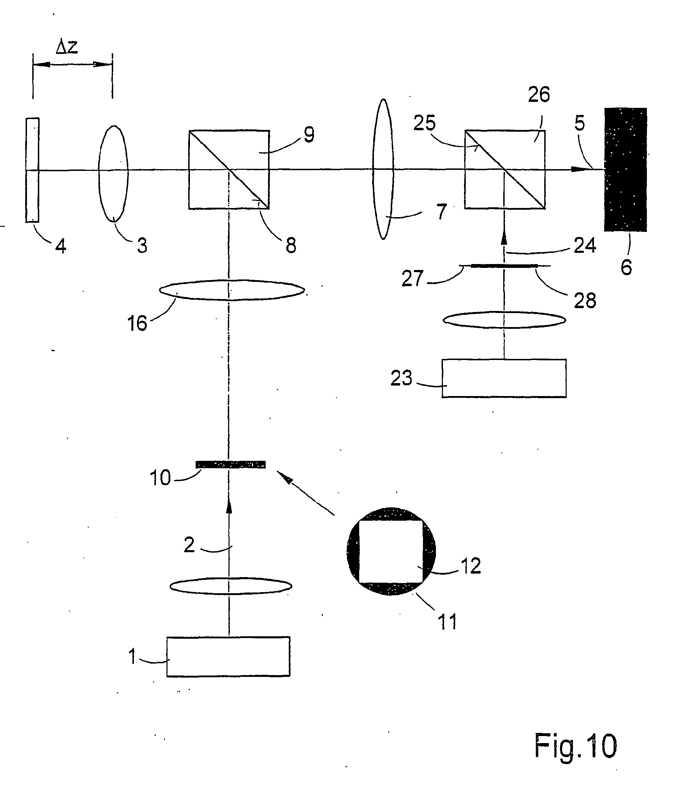

ordnung aus Fig.10,

Fig.12    die Andeutung der Kontrastschwerpunkte in den Pi- xelzeilen einer CCD-Matrix der Anordnung nach Fig.10,

Fig.13    ein Beispiel für die Verbindungsgeraden durch die Kontrastschwerpunkte

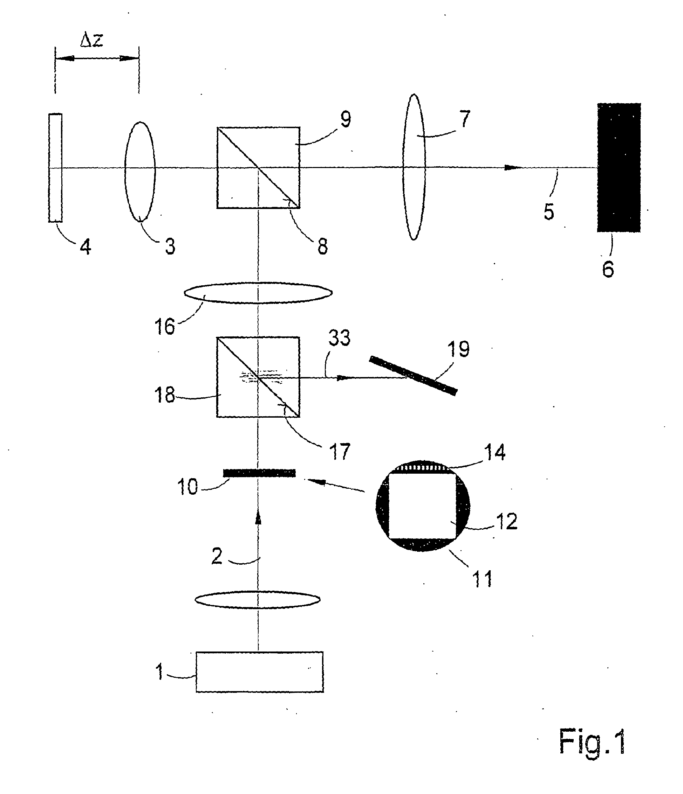

In Fig.1 ist ein abbildendes optisches System dargestellt, beispielsweise eine Mikroskopanordnung, die zur Aufnahme von Biochips genutzt werden soll. Bei der Biochip-Detektion mit Hilfe von Mikroskopen, insbesondere bei der Fluoreszenzmikroskopie, ist das Auffinden der genauen Fokusposition besonders problembehaftet.

Die Mikroskopanordnung nach Fig.1 umfaßt im wesentlichen eine Beleuchtungsquelle 1, die einen Beleuchtungsstrahlengang mit der optischen Achse 2 erzeugt, und ein Objektiv 3, durch das die Beleuchtungsquelle 1 auf die Oberfläche einer Probe 4, in diesem Fall die Oberfläche eines Biochips, abgebildet wird. Das von der Probenoberfläche reflektierte oder auch gestreute Licht gelangt als Abbildungsstrahlengang, der eine optische Achse 5 hat, zu einer Empfangseinrichtung 6, beispielsweise einer CCD-Kamera.

Dabei wird die Probenoberfläche mittels einer Abbildungsoptik, die aus dem Objektiv 3 und einer Tubuslinse 7 besteht, auf die Empfangsfläche der Empfangseinrichtung 6 abgebildet und kann so beobachtet bzw. bewertet werden.

Beleuchtungsstrahlengang und Abbildungsstrahlengang werden an der Teilerfläche 8 eines Strahlteilers 9 abgelenkt bzw. aufgespalten.

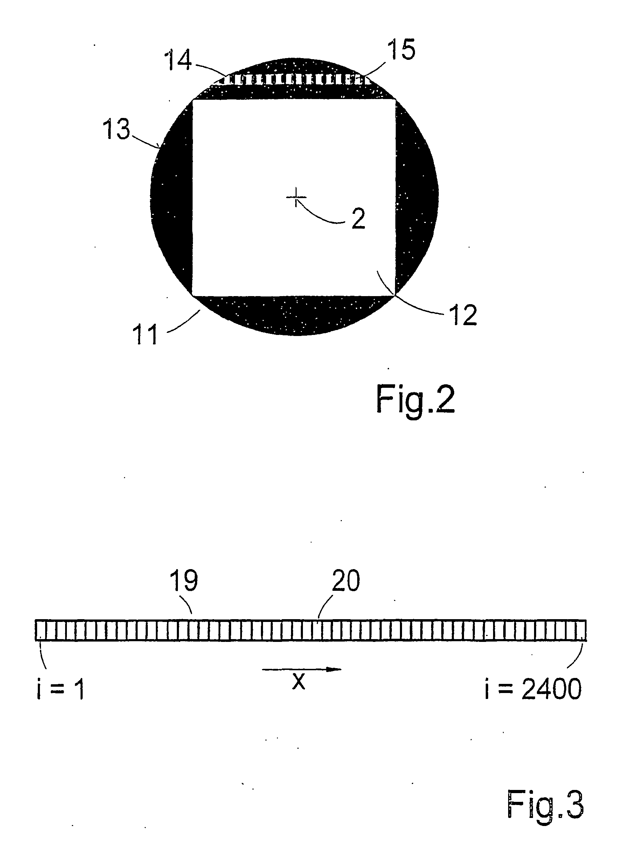

Erfindungsgemäß ist in die Blendenebene 10 des Beleuchtungsstrahlengangs eine Blendenanordnung 11 gestellt, die in Fig.2 vergrößert dargestellt ist.

Aus Fig.2 ist ersichtlich, daß die Blendenanordnung 11 eine beispielsweise quadratische Blendenöffnung 12 aufweist, die das Bildfeld festgelegt. Außerhalb der Blendenöffnung 12, jedoch innerhalb des durch die kreisförmige Begrenzung 13 gekennzeichneten Beleuchtungsstrahlengangs, ist die Spaltöffnung 14 einer Spaltblende positioniert, die mit einem Strichgitter 15 überlagert ist.

Bei der Beleuchtung der Probe 4 wird die mit der Struktur des Strichgitters 15 überlagerte Spaltöffnung 14 auf die Oberfläche der Probe 4 abgebildet. Dabei gelangt das von der Probe 4 reflektierte bzw. gestreute Licht im Abbildungsstrahlengang zurück zum Strahlteiler 9 und wird dort an der Teilerfläche 8 wieder in die Richtung des ankommenden Beleuchtungsstrahlengangs abgelenkt, passiert dabei eine Tubuslinse 16, wird an der Teilerfläche 17 eines weiteren Strahlteilers 18 aus dem Beleuchtungsstrahlengang ausgekoppelt und auf eine CCD-Zeile 19 gelenkt.

Objektiv 3 und Tubuslinse 16 wirken dabei als Abbildungsoptik und bilden die mit der Gitterstruktur überlagerte Spaltöffnung 14 auf die CCD-Zeile 19 ab. Die CCD-Zeile 19 ist relativ zur Blendenanordnung 11 geneigt. Während die Blendenanordnung 11 einschließlich der Spaltöffnung 14 senkrecht zur optischen Achse 2 des Beleuchtungsstrahlengangs ausgerichtet ist, schließt die CCD-Zeile 19 mit der optischen Achse 33 des Detektionsstrahlengangs einen Winkel ungleich 90°, bevorzugt von 45° ein.

In Fig.3 ist die CCD-Zeile 19 symbolisch dargestellt. Es ist ersichtlich, daß die CCD-Zeile 19 eine Vielzahl von in Linie angeordneten Empfangselementen aufweist, im folgenden als Pixel 20 bezeichnet. Jedem Pixel 20 ist auf der CCD-Zeile 19 eine feste Position $x_i$ zugeordnet. Weist die CCD-Zeile 19 beispielsweise eine Anzahl von 2400 Pixeln 20 auf, so sei angenommen, daß an einem Ende der CCD-Zeile 19 die Position $x_i=1$, am gegenüberliegenden Ende der CCD-Zeile 19 dagegen die Position $x_i=2400$ von einem Pixel 20 besetzt ist.

Am Ausgang jedes Pixels 20 ist ein Intensitätssignal $I(x_i)$ verfügbar, d.h. jedes Pixel 20 gibt Auskunft über die Intensität der Abbildungsstrahlung an der ihm zugeordneten Position $x_i$. Da die Spaltöffnung 14 einschließlich des Strichgitters 15 auf die schräg gestellte CCD-Zeile 19 abgebildet wird, gibt es auf der CCD-Zeile genau eine Position, bei der das Strichgitter 15 scharf abgebildete wird. Diese Position, die der aktuellen Fokusposition $P_f$ entspricht, läßt sich anhand eines oder mehrerer zugeordneter Pixel 20 ermitteln.

Mit dem erfindungsgemäßen Verfahren, das nachfolgend erläutert wird, kann die aktuelle Fokusposition genauer ermitteln, als dies nach bisherigem Stand der Technik möglich ist.

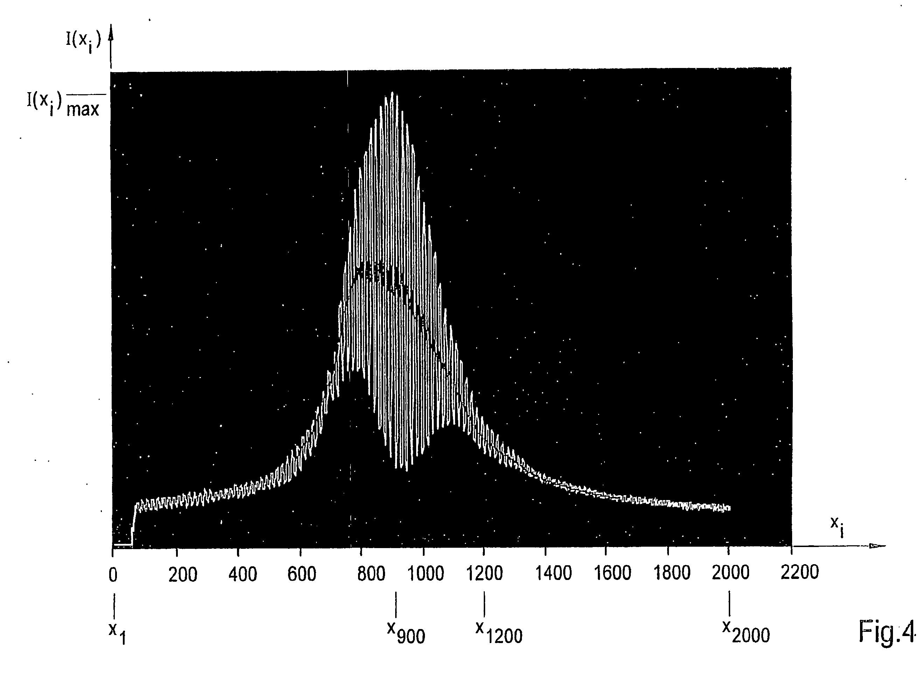

Erfindungsgemäß wird zunächst für jede Position $x_i$ eines Pixels 20 ein Intensitätswert $I(x_i)$ der aufgenommenen Strahlung bestimmt. Dabei ergibt sich über die CCD-Zeile 19 hinweg ein Intensitätsverlauf wie in Fig. 4 dargestellt. Aus Fig.4 ist ersichtlich, daß die Intensität der Abbildungsstrahlung im Bereich der Pixel $x_{700}$ bis $x_{1200}$ wesentlich stärker ist als in den übrigen Bereichen.

Es wird jedoch nicht wie im Stand der Technik die Position mit der maximalen Intensität gesucht und als aktuelle Fokusposition definiert, sondern die Intensitätswerte $I(x_i)$ werden zunächst zu positionsbezogenen Kontrastwerten weiterverarbeitet. Die positionsbezogenen Kontrastwerte $I(y_i)$ werden beispielsweise nach der Funktion ermittelt

$$\forall i \quad I(y_i) := \left| I(x_i) - I(x_{i+n}) \right|.$$

Das heißt, es wird jeweils die Differenz des Intensitätswertes $I(x_i)$ einer Position $x_i$ und eines Intensitätswertes $I(x_i+n)$ einer dazu benachbarten Position $x_{i+n}$ gebildet. Dabei ist n variabel und sollte vorteilhaft zwischen 1 und 20 gewählt werden.

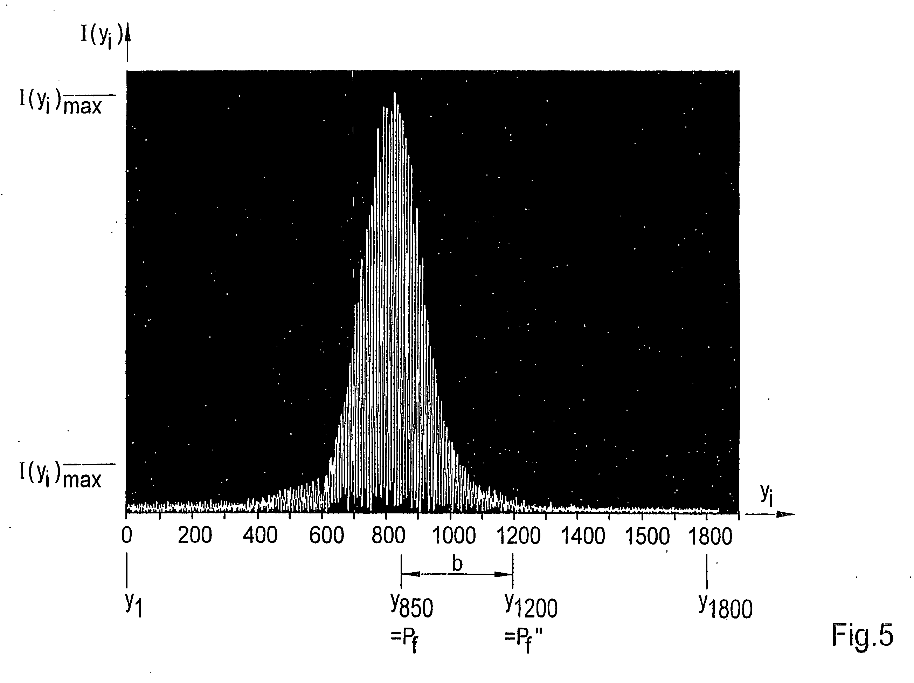

Jede so gewonnene Differenz wird als Kontrastwert $I(y_i)$ einer Position $x_i$ zugeordnet. Dabei ergibt sich ein Verlauf der Kontrastwerte $I(y_i)$ wie in Fig.5 dargestellt.

Aus Fig.5 ist ersichtlich, daß die Kontrastwerte $I(y_i)$ im Bereich $y_{600}$ bis $y_{1100}$ wesentlich größer sind als in den übrigen Bereichen der CCD-Zeile 19.

Erfindungsgemäß wird nun in einem nächsten Schritt aus den Kontrastwerten $I(y_i)$ der Kontrastschwerpunkt bestimmt nach der Funktion

$$P_f := \frac{\sum_i y_i \cdot I(y_i)}{\sum_i I(y_i)}$$

für alle Kontrastwerte $I(y_i)$, die größer sind als ein vorbestimmter Mindestwert $I_{min}$. Im vorliegenden Fall wurde $I_{min}$ beispielsweise mit einem Betrag vorgegeben wie in Fig.5 eingezeichnet.

Dieser Kontrastschwerpunkt läßt sich einem Ort auf der CCD-Zeile 19 zuordnen, der im ausgewählten Beispiel etwa bei der Position $y_{850}$ liegt. Damit ist erfindungsgemäß die aktuelle Fokusposition $P_f$ bestimmt.

In einer vorteilhaften Ausgestaltung des erfindungsgemäßen Verfahrens wird in einem nächsten Schritt die aktuelle Fokusposition $P_f$ auf der CCD-Zeile 19 verglichen mit einer idealen Fokusposition $P_f''$, die anhand einer Kalibrierung der Mikroskopanordnung, beispielsweise mittels einer glatten Probenoberfläche, bestimmt worden ist und von der hier angenommen werden soll, daß sie sich an der Position $y_{1200}$ befindet.

Im dargestellten Beispiel nach Fig.5 ergibt sich zwischen den Positionen $P_f$ und $P_f''$ ein Abstand von 350 Pixeln. Die CCD-Zeile 19 weist einen bestimmten Abstand d zwischen jeweils zwei Pixeln 20 auf; daraus läßt sich ableiten, daß in diesem Falle die aktuelle Fokusposition $P_f$ um etwa das 350-fache des Abstandes d von der idealen Fokusposition $P_f''$ entfernt ist und, um eine scharfe Abbildung der Probenoberfläche auf die Empfangseinrichtung 6 zu erhalten, die Fokusposition korrigiert werden muß.

Diese Korrektur erfolgt in der Regel durch die Veränderung des Abstandes $\Delta z$ zwischen der Probe 4 und dem Objektiv 3.

In der Praxis werden aus Gründen der Genauigkeit die Abstände d zwischen den einzelnen Pixeln auf der verwendeten CCD-Zeile durch Messungen ermittelt, und die Anordnung wird in Abhängigkeit von dem Meßergebnis kalibriert und im Kalibrierten Zustand für die Probenbewertung genutzt.

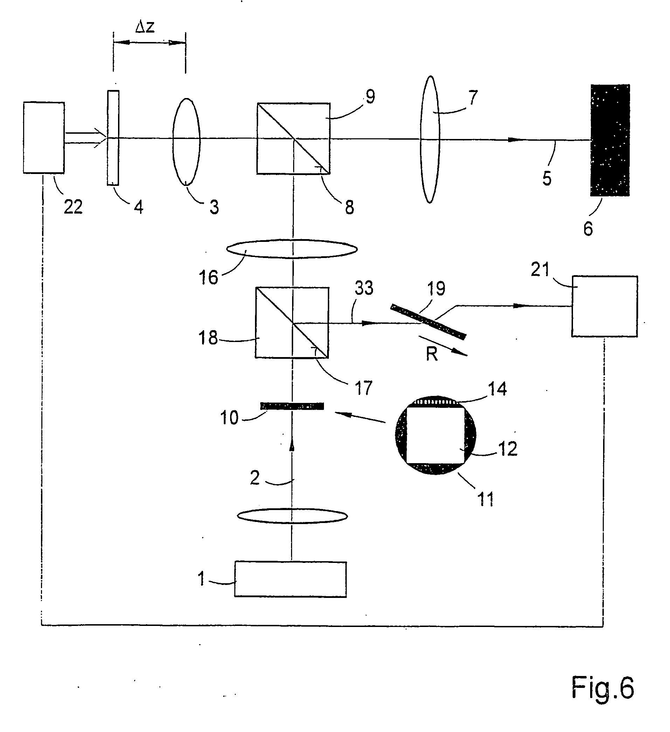

Zum Zweck der Verarbeitung der Intensitätswerte $I(x_i)$ in der vorbeschriebenen Weise und auch zur automatischen Fokussierung ist die Mikroskopanordnung wie in Fig.6 dargestellt noch mit einer Auswerteeinrichtung 21 und einer Zustelleinrichtung 22 ausgestattet, wobei die CCD-Zeile 19 mit der Auswerteeinrichtung 21 und die Auswerteeinrichtung 21 mit der Zustelleinrichtung 22 über Signalwege verbunden sind.

Die Auswerteeinrichtung 21 umfaßt einen Differenzbildner zur Ermittlung der positionsbezogenen Kontrastwerte $I(y_i)$ sowie eine Rechenschaltung zur Ermittlung des Kontrastschwerpunktes als Äquivalent für die aktuelle Fokusposition $P_f$. Weiterhin verfügt die Auswerteeinrichtung 21 über Mittel zur Vorgabe eines Wertes n=1...20 und eines Mindestwertes $I_{min}$.

Außerdem ist in der Auswerteeinrichtung 21, dem Ausführungsbeispiel nach Fig.6 entsprechend, eine Rechenschaltung vorgesehen zur Ermittlung des Abstandes b zwischen der aktuellen Fokusposition $P_f$ und dem Ort auf der CCD-Zeile 19, welcher der idealen Fokusposition $P_f''$ entspricht. Dabei ist diese Rechenschaltung zugleich auch in der Lage, einen Stellbefehl zu generieren, der über die Stelleinrichtung 22 eine Veränderung des Abstandes $\Delta z$ zwischen der Probe 4 und dem Objektiv 3 um einen zu dem Abstand b äquivalenten Betrag in einer vorgegebenen Richtung R veranlaßt.

Soll die aktuelle Fokusposition $P_f$ auf der CCD-Zeile 19 in Richtung R verschoben werden, muß ein Stellbefehl generiert werden, der dafür sorgt, daß der Abstand zwischen Objektiv 3 und Probe 4 erhöht wird. Umgekehrt müssen Stellbefehle diesen Abstand verringern, wenn die aktuelle Fokusposition $P_f$ entgegengesetzt zur Richtung R zu verschieben ist. Überdeckt sich nach Ausführung der Stellbefehle die aktuelle Fokusposition $P_f$ mit der idealen Fokusposition $P_f''$, ist die automatische Fokussierung abgeschlossen.

In einer besonderen Verfahrensvariante nach Anspruch 4, die einer höheren Anforderung an die Genauigkeit der automatischen Fokussierung gerecht wird, ist vorgesehen, daß die Auswerteeinrichtung 21 zunächst unter Berücksichtigung aller Kontrastwerte $I(y_i)$, die größer sind als ein vorbestimmter Mindestwert $I_{min}$, einen Ort $P_f'$ auf der CCD-Zeile 19 ermittelt, und erst dann in einem nachfolgenden Schritt die aktuelle Fokusposition $P_f$ ermittelt wird unter Berücksichtigung aller Kontrastwerte $I(y_i)$, die größer sind als der vorgegebene Mindestwert $I_{min}$, und die außerdem nicht weiter als um einen vorgegebenen Abstand a von dem Ort $P_f'$ entfernt sind.

Mit diesem zweistufigen Verfahren wird der Einfluß von Störungen bei der Fokussierung vermieden, indem ein korrigierter Kontrastschwerpunkt ermittelt und dieser der Bestimmung der aktuellen Fokusposition $P_f$ zugrunde gelegt wird.

Soll die Fokusposition in Bezug auf eine Grenzfläche auf oder in der Probe bestimmt werden, die zu einem Schichtsystem mit mehreren Grenzflächen gehört, so können Maßnahmen ergriffen werden, um den Kontrast für die in Fig.4 dargestellten Maxima und Minima zu erhöhen. Dies wird beispielsweise durch Anpassung der Gitterspaltbreite erreicht.

So kann die Breite des Maximums durch die Breite des Gitterspaltes verändert werden. Wird ein sehr schmaler Gitterspalt gewählt, wird auch die Intensitätsverteilung schmaler. Dadurch werden "konfokale" Bedingungen erzielt und das Licht, das von anderen Grenzflächen reflektiert wird, gelangt nicht auf die CCD-Zeile 19. Auf diese Weise kann der Kontrast der auf die CCD-Zeile 19 abgebildeten Gitterstreifen so weit erhöht werden, daß auch viel schwächer reflektierende Glas-/Wasser-Grenzflächen in der Nähe von Glas/Luft-Grenzflächen genau fokussiert und dadurch auch bezüglich ihres Abstandes zueinander genau vermessen werden können.

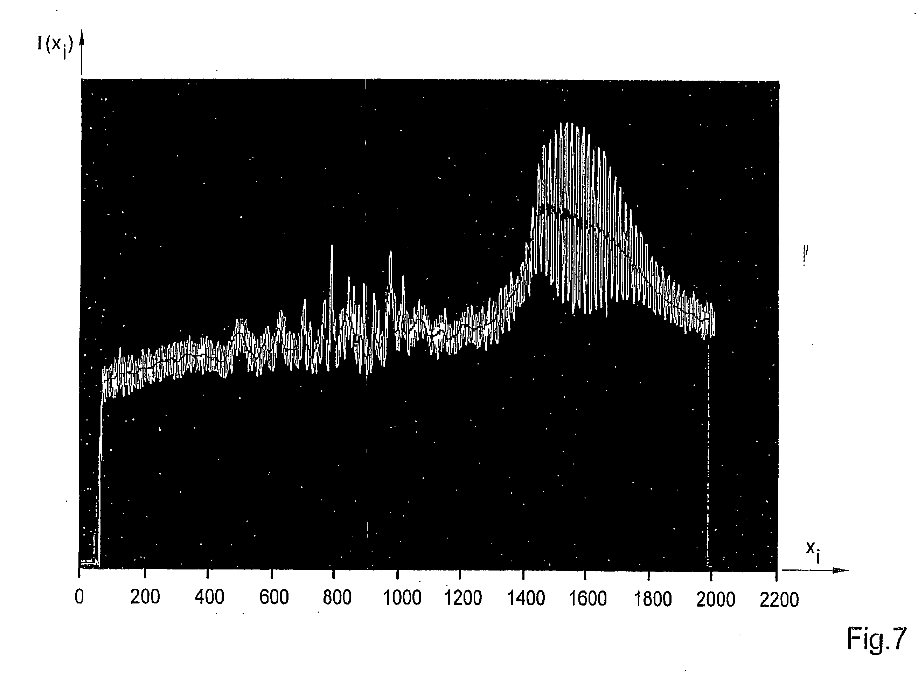

Diesbezüglich zeigt Fig.7 den Intensitätsverlauf bei der Abbildung einer Glas-/Wasser-Grenzfläche auf die CCD-Zeile 19. Dabei sind die im Bereich $x_{500}$ bis $x_{1100}$ zu erkennenden Störungen durch benachbarte streuende Grenzflächen verursacht, die einen Abstand von ca. 150 $\mu$m zueinander haben.

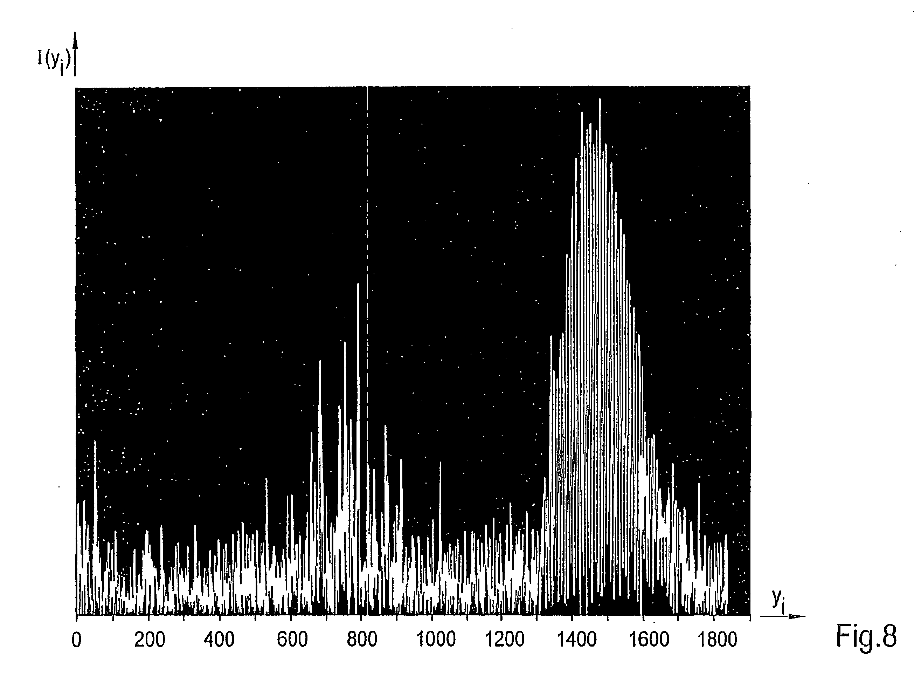

Die weitere Verarbeitung der in Fig.7 dargestellten Intensitätswerte $I(x_i)$ in der beschriebenen Weise führt zu positionsbezogenen Kontrastwerten $I(y_i)$, wie in Fig.8 dargestellt.

Bei den bisher erläuterten Ausführungen der erfindungsgemäßen Anordnung sind sowohl die Blendenöffnung 12 als auch die Spaltöffnung 14 als Bestandteile der Blendenanordnung 11 senkrecht zu der optischen Achse 2 des Beleuchtungsstrahlengangs ausgerichtet. Damit lassen sich bei der Bewertung von Proben 4, die eine nur in geringem Maße streuende Oberfläche haben, sehr gute Meßergebnisse erzielen.

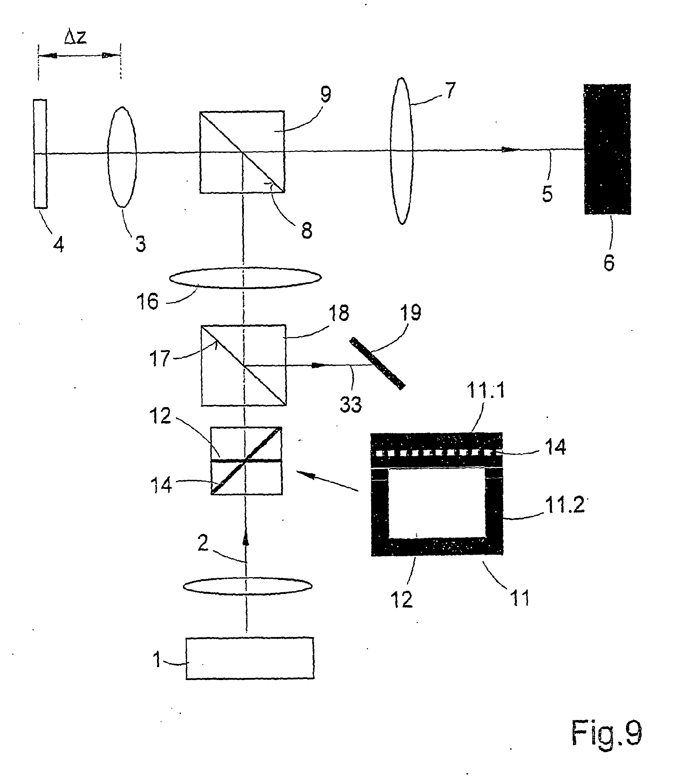

In Fig.9 dagegen ist die erfindungsgemäße Anordnung in einer Ausgestaltung dargestellt, die insbesondere zur Untersuchung von Proben 4 mit verhältnismäßig stark streuenden Oberflächen geeignet ist.

Wie in den bereits vorher erläuterten Ausgestaltungsbeispielen weist auch in der Ausführung nach Fig.9 die in der Feldblendenebene 10 positionierte Blendenanordnung 11 eine Spaltöffnung 14 und eine Blendenöffnung 12 auf, wobei auch hier die Spaltöffnung 14 der Bestimmung der Fokusposition dient und die Blendenöffnung 12 den Umfang und die Größe eines Bildausschnittes auf der Probe 4 definiert.

Dabei ist die Blendenöffnung 12 etwa zentrisch zur optischen Achse 2 des Beleuchtungsstrahlengangs ausgerichtet, und die Spaltöffnung 14 befindet sich an der Peripherie des Beleuchtungsstrahlengangs.

Als Besonderheit schließt hier die Spaltöffnung 14 mit der optischen Achse 2 einen Winkel ein, der denselben Betrag hat, um den die CCD-Zeile 19 gegen die optische Achse 33 des Detektionsstrahlengangs geneigt ist, während die Blendenöffnung 12 nach wie vor senkrecht zur optischen Achse 2 des Beleuchtungsstrahlengangs ausgerichtet ist.

Außerdem ist der optische Weg zwischen der Probe 4 und der Spaltöffnung 14 ebenso lang wie der optische Weg zwischen der Probe 4 und der CCD-Zeile 19.

Eine derartige Blendenanordnung 11 läßt beispielsweise sich technisch realisieren, indem ein Blendenteil 11.1 mit der Spaltöffnung 14 und ein Blendenteil 11.2 mit der Blendenöffnung 12 getrennt hergestellt und dann miteinander verbunden werden.

Die Voraussetzung gleicher optischer Weglängen zwischen der Spaltöffnung 14 und der Probe 4 einerseits und der Probe 4 und der CCD-Zeile 19 andererseits ist im dargestellten Falle erfüllt, wenn der Schnittpunkt, in dem sich optische Achse 2, optische Achse 33 und Teilerfläche 17 des Strahlteilers 18 treffen, vom Schnittpunkt der optischen Achse 2 mit der Spaltöffnung 14 ebenso weit entfernt ist wie der Schnittpunkt der optischen Achse 33 mit der CCD-Zeile 19.

Eine Anordnung zur Ausübung einer weiteren Variante des erfindungsgemäßen Verfahrens ist in Fig. 10 dargestellt. Diese Anordnung ist für Anwendungen geeignet, bei denen neben der genauen Bestimmung der Fokusposition auch eine Aussage zur Verkippung der Probenebene relativ zur Empfangsfläche der Empfangseinrichtung 6 zu treffen ist.

Der Übersichtlichkeit halber werden in Fig.10 soweit möglich wieder dieselben Bezugszeichen für dieselben Baugruppen verwendet wie in Fig.1.

Der Unterschied der Anordnung nach Fig. 10 zu der Anordnung nach Fig.1 besteht darin, daß eine zweite Beleuchtungsquelle 23 vorgesehen ist, von der ein zweiter Beleuchtungsstrahlengang 24 ausgeht und auf die Probe 4 gerichtet ist. Der Beleuchtungsstrahlengang 24 wird an der Teilerschicht 25 eines zusätzlichen Strahlteilers 26 in Richtung zur Probe 4 umgelenkt und im Strahlteiler 9 mit der optische Achse 2 des Beleuchtungsstrahlengangs zusammengeführt, der von der Beleuchtungsquelle 1 ausgeht.

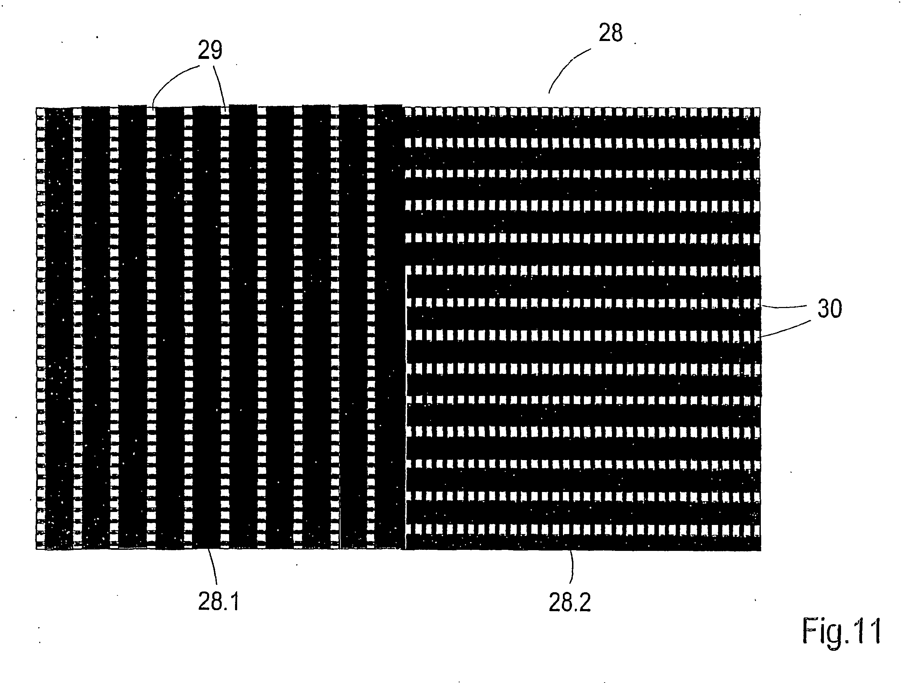

In der Feldblendenebene 27 befindet sich eine Blendenanordnung 28, die in Fig.11 vergrößert dargestellt ist. Die Blendenanordnung 28 ist aus zwei Teilblenden 28.1 und 28.2 zusammengesetzt, die beide im Beleuchtungsstrahlengang 24 nebeneinander angeordnet sind das Bildfeld, das zur Abbildung auf die Probe 4 vorgesehen ist, komplett ausfüllen.

Die Beleuchtungsquellen 1 und 23 werden alternativ betrieben, d.h. die Beleuchtungsquelle 1 wird genutzt, um die Probenoberfläche zwecks Beobachtung und Bewertung auf die CCD-Kamera der Empfangseinrichtung 6 abzubilden, während die Beleuchtungsquelle 23 lediglich zur Bestimmung der aktuellen Fokusposition und zur Bestimmung des Verkippungswinkels der Probe 4 gegen die Empfangsfläche der Empfangseinrichtung 6 genutzt wird.

Jede der beiden Teilblenden 28.1 und 28.2 besteht aus einer Anzahl parallel verlaufender Spaltöffnungen 29 und 30, von denen jede ebenso wie die Spaltöffnung 14 in der Anordnung nach Fig.1 mit einer Gitterstruktur überlagert ist. Dabei sind die Spaltöffnungen 29 der Teilblende 28.1 senkrecht zu den Spaltöffnungen 30 der Teilblende 28.2 ausgerichtet.

Die Gitterstrukturen sind jeweils senkrecht zu den Spaltöffnungen 29 bzw. 30 ausgerichtet, d.h. die Gittervektoren verlaufen parallel zur jeweiligen Spaltöffnung 29 bzw. 30.

Eine schräg gestellte CCD-Zeile 19, wie in der Anordnung nach Fig.1, ist hier nicht erforderlich. Die Blendenanordnung 28 wird auf eine CCD-Matrix in der Empfangseinrichtung 6 abgebildet, nachdem das von der Probe 4 kommende Abbildungslicht das Objektiv 3, den Strahlteiler 9, die Tubuslinse 7 und den Strahlteiler 26 passiert hat.

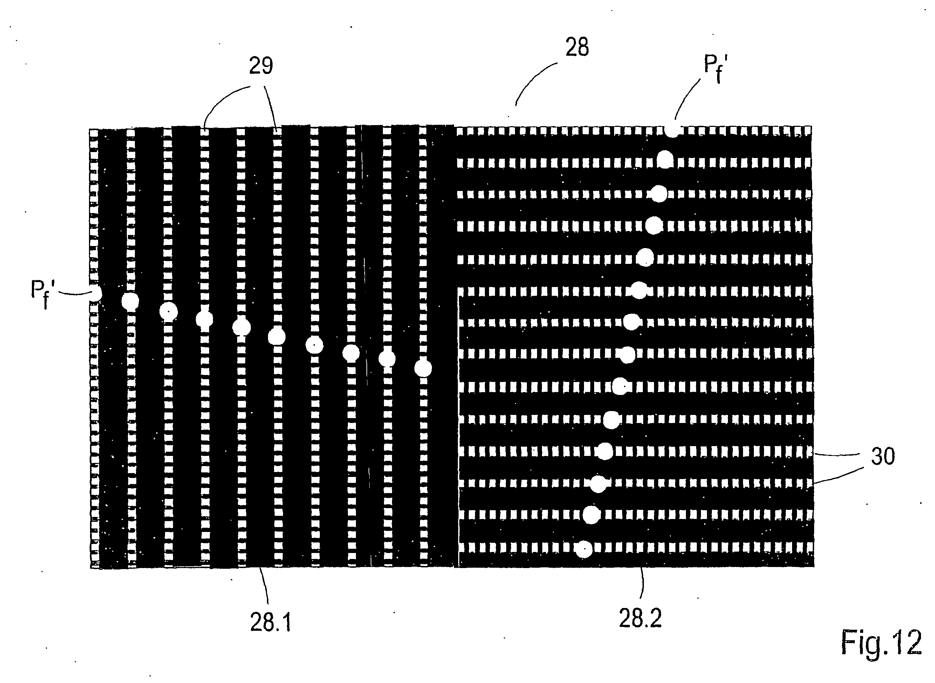

In Fig.12 ist symbolisch die CCD-Matrix dargestellt mit den durch die Abbildung der Spaltöffnungen 29 bzw. 30 in Anspruch genommenen Pixelzeilen 31 bzw. 32.

Es wird jede der Spaltöffnungen 29 einschließlich der Gitterstruktur auf eine Pixelzeile 31 auf der CCD-Matrix abgebildet und verursacht Intensitätssignale $I(x_i)$, die am Signalausgang eines jeden Pixels abgreifbar sind. Das trifft in derselben Weise zu für die Spaltöffnungen 30, die einschließlich der Gitterstruktur auf je eine Pixelzeile 32 auf der CCD-Matrix abgebildet werden.

Wie bereits weiter oben für eine einzelne CCD-Zeile 19 anhand Fig.1 beschrieben, werden auch bei dieser Verfahrensvariante die ermittelten Intensitätswerte $I(x_i)$ zu positionsbezogenen Kontrastwerten $I(y_i)$ verknüpft, wobei sich in genau derselben Weise wie bereits beschrieben auf jeder der Pixelzeilen 31 bzw. 32 ein Kontrastschwerpunkt bestimmen läßt, der jeweils die aktuelle Fokusposition $P_f$ angibt.

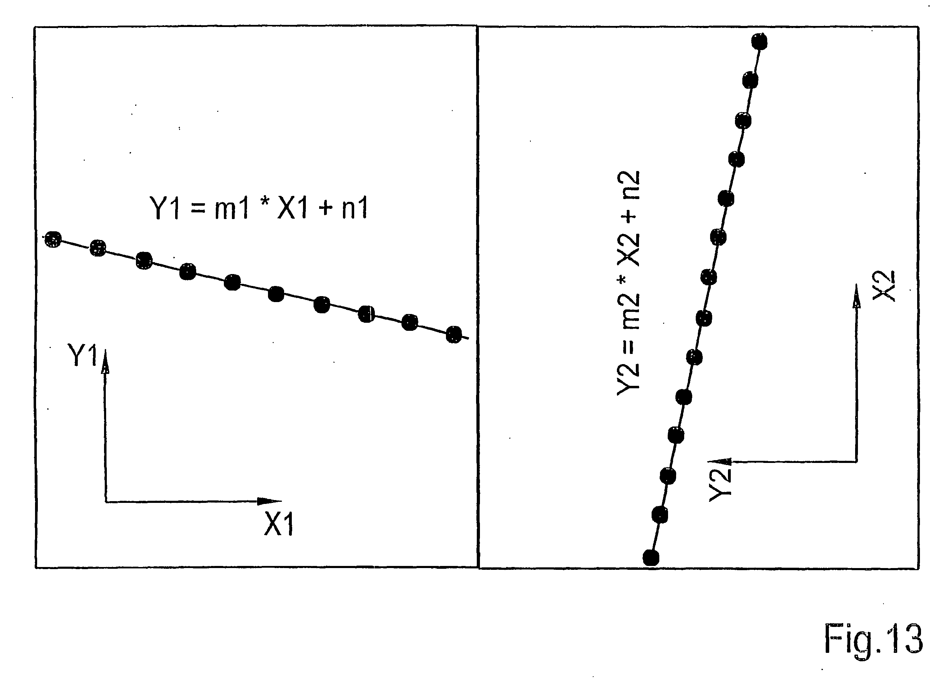

Die Kontrastschwerpunkte lassen sich für jede abgebildete Teilblende 28.1 bzw. 28.2 durch Geraden verbinden, wie in Fig.13 gesondert dargestellt. Die beiden Geraden sind durch die entsprechenden Geradengleichungen $y_1=m_1{}^*x_1+n_1$ bzw. $y_2=m_2{}^*x_2+n_2$ definiert.

Dabei ergeben die Größen $n_1$ und $n_2$ im kalibrierten Zustand ein Maß für die aktuelle Fokusposition. Entsprechen $n_1$ bzw. $n_2$ einem vorgegebenen Abstandswert, ist die Abbildungsoptik fokussiert.

Des weiteren wird unter Zugrundelegung der mathematischen Beziehungen aus der Größe $m_1$, welche die Steigung der Geraden $y_1=m_1{}^*x_1+n_1$ und damit die Abweichung von der Parallelausrichtung zur Richtung der Pixelzeilen 31 bzw. 32 beschreibt, der erste Kippwinkel und aus $m_2$ der zweite Kippwinkel der Fokusebene in Bezug auf die Ebene der Probe 4 bestimmt.

Dabei wird davon ausgegangen, daß im kalibrierten Zustand der Anordnung die Größen $m_1$ bzw. $m_2$ proportional sind zu einem Kippwinkel der Fokusebene in Bezug auf die Ebene der Probe 4.

Wird die Ebene der Probe 4 gezielt so lange verkippt, bis die beiden Größen $m_1$ bzw. $m_2$ einem Sollwert entsprechen, bevorzugt dem Wert "Null", ist die Verkippung korrigiert.

## Bezugszeichenliste

| | |
|---|---|
| 1 | Beleuchtungsquelle |
| 2 | optische Achse des Beleuch- tungsstrahlengangs |
| 3 | Objektiv |
| 4 | Probe |
| 5 | optische Achse des Abbil- dungsstrahlengangs |
| 6 | Empfangseinrichtung |
| 7 | Tubuslinse |
| 8 | Teilerfläche |
| 9 | Strahlteiler |
| 10 | Feldblendenebene |
| 11 | Blendenanordnung |
| 12 | Blendenöffnung |
| 13 | Begrenzung |
| 14 | Spaltöffnung |
| 15 | Strichgitter |
| 16 | Tubuslinse |
| 17 | Teilerfläche |
| 18 | Strahlteiler |
| 19 | CCD-Zeile |
| 20 | Pixel |
| 21 | Auswerteeinrichtung |
| 22 | Zustelleinrichtung |
| 23 | Beleuchtungsquelle |
| 24 | Beleuchtungsstrahlengang |
| 25 | Teilerfläche |
| 26 | Strahlteiler |
| 27 | Blendenebene |
| 28 | Blendenanordnung |
| 28.1, 28.2 | Teilblenden |
| 29, 30 | Spaltöffnungen |
| 31, 32 | Pixelzeilen |
| 33 | optische Achse eines Detek- tionsstrahlengangs |

## Patentansprüche

1. Verfahren zur Bestimmung der Fokusposition bei der Abbildung einer Probe (4), bei dem

   - eine Feldblende auf die Probe (4) abgebildet und die Abbildung der Feldblende auf der Probe (4) zumindest teilweise durch die Abbildung eines optischen Gitters überlagert wird,
   - mittels einer relativ zur Feldblende geneigten positionsempfindlichen Empfangseinrichtung Intensitätswerte $I(x_i)$ für das von der Probe (4) reflektierte Licht gewonnen und Positionen auf der Empfangseinrichtung zugeordnet werden,
   - aus den Intensitätswerten $I(x_i)$ positionsbezogene Kontrastwerte ermittelt werden aus jeweils der Differenz eines Intensitätswertes $I(x_i)$, der einer Position i auf der Empfangseinrichtung zugeordnet ist, und einem Intensitätswert $I(x_{i+n})$, der einer benachbarten Position i+n zugeordnet ist, und
   - anhand dieser Kontrastwerte $I(y_i)$ die Position des Kontrastschwerpunktes auf der Empfangseinrichtung als Äquivalent für die aktuelle Fokusposition ermittelt wird für alle Kontrastwerte $I(y_i)$, die größer sind als ein vorbestimmter Mindestwert $I_{min}$.

**2.** Verfahren nach Anspruch 1, **dadurch gekennzeichnet, daß** positionsbezogene Kontrastwerte I $(y_i)$ nach der Funktion

$$\forall i \quad I(y_i) := \left| I(x_i) - I(x_{i+n}) \right|$$

ermittelt werden, mit den Intensitätswerten $I(x_i)$ und $I(x_{i+n})$, Positionen i auf der Empfangseinrichtung und mit n = 1...20.

**3.** Verfahren nach Anspruch 1 oder 2, **dadurch gekennzeichnet, daß** als Äquivalent für die aktuelle Fokusposition $P_f$ ein Ort ermittelt wird nach der Funktion

$$P_f := \frac{\sum_i y_i \cdot I(y_i)}{\sum_i I(y_i)}.$$

für alle Kontrastwerte $I(y_i)$, die größer sind als ein vorbestimmter Mindestwert $I_{min}$.

**4.** Verfahren nach Anspruch 1 oder 2, **dadurch gekennzeichnet, daß**

    - in einem ersten Schritt ein Ort $P_f'$ ermittelt wird nach der Funktion

$$P_f' := \frac{\sum_i y_i \cdot I(y_i)}{\sum_i I(y_i)}$$

    für alle Kontrastwerte $I(y_i)$, die größer sind als ein vorbestimmter Mindestwert $I_{min}$ und
    - in einem zweiten Schritt als Äquivalent für die aktuelle Fokusposition. $P_f$ ein Ort ermittelt wird nach der Funktion

$$P_f := \frac{\sum_i y_i \cdot I(y_i)}{\sum_i I(y_i)}$$

    für alle Kontrastwerte $I(y_i)$, die größer als ein Mindestwert $I'_{min}$ und nicht weiter als um einen vorgegebenen Abstand a von dem Ort $P_f'$ entfernt sind.

**5.** Verfahren nach einem der vorgenannten Ansprüche, **dadurch gekennzeichnet, daß**

    - eine Feldblende mit einer Spaltöffnung (14), als optisches Gitter ein Strichgitter (15) in Form einer streifenförmigen Maske und als Empfangseinrichtung eine CCD-Zeile (19) genutzt werden,
    - die Positionen i durch die fortlaufende Numerierung der Pixel (20) der CCD-Zeile (19) charakterisiert sind, und
    - der Abstand a mit einer Anzahl Pixel (20) im Bereich a = 10...1000 vorgegeben wird.

**6.** Verfahren nach einem der vorgenannten Ansprüche, **dadurch gekennzeichnet, daß** aus dem auf der Empfangseinrichtung gemessenen Abstand b zwischen dem Ort $P_f$ und einem Ort $P_f''$, welcher der idealen Fokusposition auf der Empfangseinrichtung entspricht, ein Stellsignal zur automatischen Fokussierung generiert wird, bevorzugt durch Änderung des Abstandes $\Delta z$ zwischen der Probe (4) und einer Abbildungsoptik.

**7.** Verfahren nach einem der vorgenannten Ansprüche, **dadurch gekennzeichnet, daß**

    - als Feldblende eine Rechteckblende und
    - als Empfangseinrichtung eine CCD-Matrix verwendet wird und
    - das optische Gitter aus zwei in der Gitterebene gegeneinander geneigten Gitterstreifenmasken besteht, von denen jede mehrere parallel zueinander verlaufende streifenförmige Masken aufweist, wobei
    - von jeder streifenförmigen Maske eine Abbildung auf der Probe erzeugt und für jede abgebildete Maske die Position des Kontrastschwerpunktes wie in den Ansprüchen 2 bis 4 beschrieben als Äquivalent einer aktuellen Fokusposition auf der CCD-Matrix bestimmt wird,
    - der Verlauf und die Neigung der beiden Verbindungsgeraden durch die Kontrastschwerpunkte ermittelt wird und
    - daraus der Verkippungswinkel der Fokusebene in Bezug auf die Empfangsfläche der CCD-Matrix bestimmt wird.

**8.** Verfahren nach Anspruch 7, **dadurch gekennzeichnet, daß** aus dem Verkippungswinkel der Fokusebene in Bezug auf die Ebene der Empfangsfläche der CCD-Matrix ein Stellsignal zur Kompensation des Verkippungswinkels abgeleitet wird.

**9.** Verfahren nach einem der vorgenannten Ansprüche, **dadurch gekennzeichnet, daß** die Spaltbreite der optischen Gitter in Abhängigkeit vom Reflexionsvermögen eines ausgewählten Probenabschnitts und/oder der Intensität von störendem gestreuten oder reflektierten Licht festgelegt wird, wobei zwecks Erhöhung der Genauigkeit bei der Bestimmung des Kontrastschwerpunktes und damit der aktuellen Fokusposition die Spaltbreite um so kleiner vorgegeben wird, je geringer das Reflexionsvermögen des Probenabschnitts oder je intensiver störendes gestreutes oder reflektiertes Licht ist.

10. Verfahren nach einem der vorgenannten Ansprüche, **dadurch gekennzeichnet, daß**

  - die Intensitätswerte benachbarter Pixel (20) der Empfangseinrichtung über eine Periode des abgebildeten Gitters gemittelt werden,
  - die Abweichung des dabei erhaltenen Intensitätssignals $I_{ist}$ von einem vorgegebenen Intensitätssignal $I_{soll}$ bestimmt wird und
  - zwecks Kompensation von durch Schmutzpartikel im optischen Strahlengang oder anderweitig verursachter Störungen eine Korrektur der Kontrastwerte $I(y_i)$ vorgenommen wird, welche die Abweichung ausgleicht.

11. Verfahren nach Anspruch 10, **dadurch gekennzeichnet, daß** die Mittelung der Intensitätswerte benachbarter Pixel (20) vorgenommen wird nach der Funktion

$$I(x_i) := \frac{1}{n}\sum_{j=0}^{n} J\left(x_{i+j-\frac{n}{2}}\right)$$

für alle $x_i$ mit n=2...100, wobei bevorzugt n der Anzahl der Pixel je Gitterperiode entspricht.

12. Anordnung zur Bestimmung der Fokusposition nach den vorgenannten Verfahrensschritten, insbesondere bei einem Mikroskop, umfassend

  - eine Beleuchtungsquelle (1) zur Erzeugung eines Beleuchtungsstrahlengangs,
  - eine Abbildungsoptik, durch die der Beleuchtungsstrahlengang auf die Probe (4) gerichtet ist und
  - eine in einem Abbildungsstrahlengang angeordnete Kamera,
  **dadurch gekennzeichnet, daß**
  - in der Feld blenden ebene (10) - in den Beleuchtungsstrahlengang eine durch eine Gittermaske überlagerte Spaltöffnung (14) gestellt ist,
  - ein aus dem Abbildungsstrahlengang abgezweigter Detektionsstrahlengang auf eine CCD-Zeile (19) gerichtet ist, die mit der optischen Achse (33) des Detektionsstrahlengangs einen Winkel $\alpha \neq 90°$ einschließt,
  - die CCD-Zeile (19) mit einer Auswerteeinrichtung (21) zur Ermittlung von positionsbezogenen Intensitätswerten $I(x_i)$ und von positionsbezogenen Kontrastwerten $I(y_i)$ in Verbindung

steht, und
  - die Auswerteeinrichtung (21) zur Ermittlung der Position des Kontrastschwerpunktes auf der CCD-Zeile (19) als ein Äquivalent für die aktuelle Fokusposition ausgebildet ist, wobei
  - die positionsbezogenen Kontrastwerte ermittelt werden aus jeweils der Differenz eines Intensitätswertes $I(x_i)$, der einer Position i auf der CCD-Zeile (19) zugeordnet ist, und einem Intensitätswert $I(x_{i+n})$, der einer benachbarten Position i+n zugeordnet ist, und wobei
  - die Position des Kontrastschwerpunktes auf der Empfangseinrichtung ermittelt wird für alle Kontrastwerte $I(y_i)$, die größer sind als ein vorbestimmter Mindestwert $I_{min}$.

13. Anordnung nach Anspruch 12, **dadurch gekennzeichnet, daß**

  - die Spaltöffnung (14) gemeinsam mit einer Blendenöffnung (12), die den Umfang und die Größe eines Bildausschnitts auf der Probe (4) definiert, in einer Feldblendenebene (10) positioniert ist, wobei
  - die Blendenöffnung (12) zentrisch zur optischen Achse (2) des Beleuchtungsstrahlengangs ausgerichtet ist und sich die Spaltöffnung (14) an der Peripherie des Beleuchtungsstrahlengangs befindet.

14. Anordnung nach Anspruch 13, **dadurch gekennzeichnet, daß**

  - die Blendenöffnung (12) senkrecht zur optischen Achse (2) des Beleuchtungsstrahlengangs ausgerichtet ist, während
  - die Spaltöffnung (14) mit der optischen Achse (2) einen Winkel einschließt, der dem Winkel entspricht, um den die CCD-Zeile (19) gegen die optische Achse (33) des Detektionsstrahlengangs geneigt ist, wobei
  - die optische Weglänge zwischen der Probe (4) und der Spaltöffnung (14) ebenso groß ist wie die optische Weglänge zwischen der Probe (4) und der CCD-Zeile (19).

15. Anordnung nach einem der Ansprüche 12 bis 14, **dadurch gekennzeichnet, daß** die Auswerteeinrichtung (21) umfaßt

  - einen Differenzbildner, der positionsbezogene Kontrastwerte $I(y_i)$ nach der Funktion

$$\forall i \quad I(y_i) := |I(x_i) - I(x_{i+n})|$$

ermittelt, mit den Intensitätswerten $I(x_i)$ und $I$

$(x_{i+n})$, Positionen i auf der Empfangseinrichtung und mit n = 1....20, und

- eine Rechenschaltung, die den Kontrastschwerpunkt ermittelt als Äquivalent für die aktuelle Fokusposition nach der Funktion

$$P_f := \frac{\sum_i y_i \cdot I(y_i)}{\sum_i I(y_i)}$$

für alle Kontrastwerte $I(y_i)$, die größer sind als ein vorbestimmter Mindestwert $I_{min}$.

16. Anordnung nach einem der Ansprüche 12-15, **dadurch gekennzeichnet, daß**

- in der Auswerteeinrichtung eine Rechenschaltung vorgesehen ist zur Ermittlung des Abstand b zwischen dem Ort $P_f$ und einem Ort $P_f''$, welcher der idealen Fokusposition auf der CCD-Zeile (19) entspricht, und
- die Auswerteeinrichtung (21) mit einer Zustelleinrichtung (22) zur Änderung des Abstandes $\Delta z$ zwischen der Probe (4) und der Abbildungsoptik in Verbindung steht.

17. Anordnung nach einem der Ansprüche 12 bis 16, **dadurch gekennzeichnet, daß** die Frequenz des Gitters der optischen Auflösungsgrenze der Abbildungsoptik angepaßt ist, wobei bevorzugt jeweils fünf Pixel (20) der CCD-Zeile (19) einer Gitter-Periode entsprechen.

**Claims**

1. Method for determining the focal position in the imaging of a sample (4), wherein

- a field stop is imaged onto the sample (4) and the image of the field stop on the sample (4) is at least partially overlaid by the image of an optical grating,
- by means of a position-sensitive reception device which is inclined relative to the field stop, intensity values $I(x_i)$ for the light reflected by the sample (4) are obtained and assigned to positions on the reception device,
- from the intensity values $I(x_i)$, position-related contrast values are determined respectively from the difference between an intensity value $I(x_i)$, which is assigned to a position i on the reception device, and an intensity value $I(x_{i+n})$ which is assigned to a neighbouring position i+n, and
- with the aid of these contrast values $I(y_i)$, the

position of the contrast centroid on the reception device is determined as an equivalent for the current focal position, for all contrast values $I(y_i)$ which are greater than a predetermined minimum value $I_{min}$.

2. Method according to Claim 1, **characterised in that** position-related contrast values $I(y_i)$ are determined according to the function

$$\forall i \quad I(y_i) := \left| I(x_i) - I(x_{i+n}) \right|$$

with the intensity values $I(x_i)$ and $I(x_{i+n})$, positions i on the reception device and with n = 1...20.

3. Method according to Claim 1 or 2, **characterised in that** as an equivalent for the current focal position $P_f$, a location is determined according to the function

$$P_f := \frac{\sum_i y_i \cdot I(y_i)}{\sum_i I(y_i)}$$

for all contrast values $I(y_i)$ which are greater than a predetermined minimum value $I_{min}$.

4. Method according to Claim 1 or 2, **characterised in that**

- in a first step, a location $P_f'$ is determined according to the function

$$P_f' := \frac{\sum_i y_i \cdot I(y_i)}{\sum_i I(y_i)}$$

for all contrast values $I(y_i)$ which are greater than a predetermined minimum value $I_{min}$ and
- in a second step, as an equivalent of the current focal position $P_f$, a location is determined according to the function

$$P_f := \frac{\sum_i y_i \cdot I(y_i)}{\sum_i I(y_i)}$$

for all contrast values $I(y_i)$ which are greater than a predetermined minimum value $I'_{min}$ and not further than a predetermined distance a from the location $P_f$'.

5. Method according to one of the preceding claims, **characterised in that**

- a field stop with a slit aperture (14) is used, a line grating (15) in the form of a strip-shaped mask is used as the optical grating, and a CCD linear array (19) is used as the reception device,
- the positions i are **characterised by** continuous numbering of the pixels (20) of the CCD linear array, and
- the distance a is specified by a number of pixels (20) in the range a=10...1000.

6. Method according to one of the preceding claims, **characterised in that** a control signal is generated for automatic focusing, preferably by changing the distance $\Delta z$ between the sample (4) and a set of imaging optics, from the distance b measured on the reception device between the location $P_f$ and a location $P_f$" which corresponds to the ideal focal position on the reception device.

7. Method according to one of the preceding claims, **characterised in that**

- a rectangular stop is used as the field stop,
- a CCD matrix is used as the reception device and
- the optical grating consists of two grating strip masks inclined relative to one another in the grating plane, each of which has a plurality of strip-shaped masks extending parallel to one another, wherein
- an image of each strip-shaped mask is generated on the sample and, for each imaged mask, the position of the contrast centroid is determined as described in Claims 2 to 4 as an equivalent of a current focal position on the CCD matrix,
- the profile and the inclination of the two connecting straight lines through the contrast centroids is determined and
- the tilt angle of the focal plane in relation to the reception surface of the CCD matrix is determined therefrom.

8. Method according to Claim 7, **characterised in that** a control signal to compensate for the tilt angle is derived from the tilt angle of the focal plane in relation to the plane of the reception surface of the CCD matrix.

9. Method according to one of the preceding claims, **characterised in that** the slit width of the optical grating is established as a function of the reflectivity of a selected sample section and/or the intensity of perturbing scattered or reflected light, wherein for the purpose of increasing the accuracy when determining the contrast centroid and therefore the current focal position, the slit width is set commensurately smaller when the reflectivity of the sample section is less or the perturbing scattered or reflected light is more intense.

10. Method according to one of the preceding claims, **characterised in that**

- the intensity values of neighbouring pixels (20) of the reception device are averaged over a period of the imaged grating,
- the deviation of the intensity signal $I_{actual}$ thereby obtained from a predetermined intensity signal $I_{setpoint}$ is determined and
- a correction of the contrast values $I(y_i)$ which balances out the deviation, is carried out for the purpose of compensating for perturbations caused by dirt particles in the optical beam path or in another way.

11. Method according to Claim 10, **characterised in that** the averaging of the intensity values of neighbouring pixels (20) is carried out according to the function

$$I(x_i) := \frac{1}{n} \sum_{j=0}^{n} J\left(x_{i+j-\frac{n}{2}}\right)$$

for all $x_i$ with n=2...100, n preferably corresponding to the number of pixels per grating period.

12. Arrangement for determining the focal position according to the preceding method steps, particularly in a microscope, comprising

- an illumination source (1) for generating an illumination beam path,
- a set of imaging optics, by which the illumination beam path is directed onto the sample (4) and
- a camera arranged in an imaging beam path, **characterised in that**
- a slit aperture (14) overlaid by a grating mask is placed in the field stop plane (10) in the illumination beam path,
- a detection beam path branched off from the imaging beam path is directed onto a CCD linear array (19), which makes an angle $\alpha \neq 90°$ with the optical axis (33) of the detection beam path,
- the CCD linear array (19) is connected to an evaluation device (21) for determining position-related intensity values $I(x_i)$ and position-related

contrast values I($y_i$), and
- the evaluation device (21) is adapted to determine the position of the contrast centroid on the CCD linear array (19) as an equivalent for the current focal position, wherein
- the position-related contrast values are determined respectively from the difference between an intensity value I($x_i$), which is assigned to a position i on the CCD linear array (19), and an intensity value I($x_{i+n}$) which is assigned to a neighbouring position i+n, and wherein
- the position of the contrast centroid on the reception device is determined for all contrast values I($y_i$) which are greater than a predetermined minimum value I$_{min}$.

**13.** Arrangement according to Claim 12, **characterised in that**

- the slit aperture (14) together with a stop aperture (12), which defines the shape and the size of an image section on the sample (4), is positioned in a field stop plane (10), wherein
- the slit aperture (12) is aligned centrally with respect to the optical axis (2) of the illumination beam path and the slit aperture (14) is located on the periphery of the illumination beam path.

**14.** Arrangement according to Claim 13, **characterised in that**

- the stop aperture (12) is aligned perpendicularly to the optical axis (2) of the illumination beam path, whereas
- the slit aperture (14) makes an angle with the optical axis (2), which corresponds to the angle by which the CCD linear array (19) is inclined relative to the optical axis (33) of the detection beam path, wherein
- the optical path length between the sample (4) and the slit aperture (14) is equal in value to the optical path length between the sample (4) and the CCD linear array (19).

**15.** Arrangement according to one of Claims 12 to 14, **characterised in that** the evaluation device (21) comprises

- a differencer, which determines position-related contrast value is I($y_i$) according to the function

$$\forall i \quad I(y_i) := \left| I(x_i) - I(x_{i+n}) \right|$$

with the intensity values I($x_i$) and I($x_{i+n}$), positions i on the reception device and with n = 1... 20, and

- a computation circuit, which determines the contrast centroid as an equivalent for the current focal position according to the function

$$P_f := \frac{\sum_i y_i \cdot I(y_i)}{\sum_i I(y_i)}$$

for all contrast values I($y_i$) which are greater than a predetermined minimum value I$_{min}$.

**16.** Arrangement according to one of Claims 12-15, **characterised in that**

- in the evaluation device, a computation circuit is provided for determining the distance b between the location $P_f$ and a location $P_f''$ which corresponds to the ideal focal position on the CCD linear array (19), and
- the evaluation device (21) is connected to an adjustment device (22) for changing the distance $\Delta z$ between the sample (4) and the set of imaging optics.

**17.** Arrangement according to one of Claims 12 to 16, **characterised in that** the frequency of the grating is adapted to the resolution limit of the set of imaging optics, preferably with five pixels (20) of the CCD linear array (19) respectively corresponding to one grating period.

**Revendications**

**1.** Procédé pour déterminer la position du foyer lors de la représentation d'un échantillon (4), dans lequel

- un obturateur de zone est représenté sur l'échantillon (4) et la représentation de l'obturateur de zone sur l'échantillon (4) est recouvert au moins en partie par la représentation d'une grille optique,
- des valeurs d'intensité I($x_i$) pour la lumière réfléchie par l'échantillon (4) sont obtenues au moyen d'un dispositif de réception sensible à la position et incliné par rapport à l'obturateur de zone et des positions sur le dispositif de réception sont attribuées,
- des valeurs de contraste spécifiques à la position sont déterminées à partir des valeurs d'intensité I($x_i$) à partir de respectivement la différence entre une valeur d'intensité I($x_i$), qui est attribuée à une position i sur le dispositif de réception, et une valeur d'intensité I($x_{i+n}$), qui est attribuée à une position voisine i+n, et
- la position de l'élément principal de contraste sur le dispositif de réception est déterminée à l'aide de ces valeurs de contraste I(y$_i$) comme équivalent pour la position de foyer actuelle pour toutes les valeurs de contraste I(y$_i$), qui sont supérieures à une valeur minimale I$_{min}$ prédéfinie.

2. Procédé selon la revendication 1, **caractérisé en ce que** des valeurs de contraste I(y$_i$) spécifiques à la position sont déterminées selon la fonction

$$\forall i \qquad I(y_i) := |I(x_i)\text{-}I(x_{i+n})|$$

avec les valeurs d'intensité I(x$_i$) et I(x$_{i+n}$), des positions i sur le dispositif de réception et avec n = 1...20.

3. Procédé selon la revendication 1 ou 2, **caractérisé en ce que**, comme équivalent pour la position de foyer P$_f$ actuelle, on détermine un lieu selon la fonction :

$$P_f = \frac{\sum_i y_i.I(y_i)}{\sum_i I(y_i)}$$

pour toutes les valeurs de contraste I(y$_i$) qui sont supérieures à une valeur minimale I$_{min}$ prédéfinie.

4. Procédé selon la revendication 1 ou 2, **caractérisé en ce que**

- dans une première étape, on détermine un lieu P$_{f'}$ selon la fonction

$$P_f' = \frac{\sum_i y_i.I(y_i)}{\sum_i I(y_i)}$$

pour toutes les valeurs de contraste I(y$_i$) qui sont supérieures à une valeur minimale I$_{min}$ prédéfinie et
- dans une seconde étape, on détermine comme équivalent pour la position de foyer P$_f$ actuelle un lieu selon la fonction

$$P_f = \frac{\sum_i y_i.I(y_i)}{\sum_i I(y_i)}$$

pour toutes les valeurs de contraste I(y$_i$) qui sont supérieures à une valeur minimale I'$_{min}$ et ne sont pas éloignées de plus d'une distance a prédéfinie du lieu Pr.

5. Procédé selon l'une quelconque des revendications précédentes, **caractérisé en ce que**

- on utilise un obturateur de zone avec une ouverture de fente (14), comme grille optique un réticule (15) sous la forme d'un masque en forme de bande et comme dispositif de réception une ligne CCD (19),
- les positions i sont **caractérisées par** la numérotation continue des pixels (20) de la ligne CCD (19), et
- la distance a est prédéterminée avec un nombre de pixels (20) situé dans la plage a = 10... 1000.

6. Procédé selon l'une quelconque des revendications précédentes, **caractérisé en ce que**, à partir de la distance b mesurée sur le dispositif de réception entre le lieu P$_f$ et un lieu P$_{f'}$, qui correspond à la position de foyer idéale sur le dispositif de réception, on génère un signal de positionnement pour la mise au point automatique, de préférence par modification de la distance $\Delta z$ entre l'échantillon (4) et une optique de reproduction.

7. Procédé selon l'une quelconque des revendications précédentes, **caractérisé en ce que**

- on utilise comme obturateur de zone un obturateur rectangulaire et
- comme dispositif de réception une matrice CCD et
- la grille optique est constituée de deux masques à bande de grille inclinés l'un par rapport à l'autre dans le plan de grille, masques dont chacun présente plusieurs masques en forme de bande, agencés parallèlement entre eux,
- une représentation sur l'échantillon étant générée par chaque masque en forme de bande et la position de l'élément principal de contraste étant déterminée pour chaque masque reproduit, comme décrit dans les revendications 2 à 4, comme équivalent d'une position de foyer actuelle sur la matrice CCD,
- le tracé et l'inclinaison des deux droites de liaison étant déterminés par les éléments principaux de contraste et
- l'angle de basculement du plan de foyer par rapport à la surface de réception de la matrice CCD étant déterminé à partir de là.

8. Procédé selon la revendication 7, **caractérisé, en ce qu'**à partir de l'angle de basculement du plan de foyer par rapport au plan de la surface de réception de la matrice CCD, on déduit un signal de positionnement pour la compensation de l'angle de basculement.

**9.** Procédé selon l'une quelconque des revendications précédentes, **caractérisé en ce que** la largeur de fente des grilles optiques est définie en fonction de la capacité de réception d'une partie d'échantillon sélectionnée et/ou de l'intensité de lumière diffusée ou réfléchie parasite, la largeur de fente étant prédéfinie, pour améliorer la précision lors du calcul de l'élément principal de contraste et donc de la position de foyer actuelle, d'autant plus petite que la capacité de réception du tronçon d'échantillon est plus faible ou que de la lumière diffusée ou réfléchie parasite est plus intense.

**10.** Procédé selon l'une quelconque des revendications précédentes, **caractérisé en ce que**

- les valeurs d'intensité de pixels (20) voisins du dispositif de réception sont calculées en moyenne sur une période de la grille reproduite,
- l'écart entre le signal d'intensité $I_{ist}$ ainsi obtenu et un signal d'intensité $I_{soll}$ prédéfini est déterminé et
- une correction des valeurs de contrat $I(y_i)$, qui compense l'écart, est effectuée pour la compensation de perturbations provoquées par des particules de poussière dans la trajectoire de faisceau optique ou d'une autre façon.

**11.** Procédé selon la revendication 10, **caractérisé en ce que** le calcul de la moyenne des valeurs d'intensité de pixels (20) voisins est effectué selon la fonction

$$I(x_i) := \frac{1}{n}\sum_{j=0}^{n} J\left(x_{i+j-\frac{n}{2}}\right)$$

pour tous les $x_i$ avec n=2...100, n correspondant de préférence au nombre des pixels par période de grille.

**12.** Agencement pour déterminer la position de foyer selon les étapes de procédé susmentionnées, en particulier dans le cas d'un microscope, comprenant

- une source d'éclairage (1) pour générer une trajectoire de faisceau d'éclairage,
- une optique de reproduction, par laquelle la trajectoire du faisceau d'éclairage est axée sur l'échantillon (4) et
- une caméra disposée dans une trajectoire de faisceau de reproduction,
**caractérisé en ce que**
- une ouverture de fente (14) recouverte par un masque de grille est placée dans le plan d'obturateur de zone (10) dans la trajectoire du faisceau d'éclairage,
- une trajectoire de faisceau d'éclairage déviée de la trajectoire de faisceau de reproduction est axé sur une ligne CCD (19), laquelle forme un angle $\alpha = 90°$ avec l'axe (33) optique de la trajectoire du faisceau de détection,
- la ligne CCD (19) est en liaison avec un dispositif d'analyse (21) pour déterminer des valeurs d'intensité $I(x_i)$ spécifiques à la position et des valeurs de contraste $I(y_i)$ spécifiques à la position, et
- le dispositif d'analyse (21) pour déterminer la position de l'élément principal de contraste sur la ligne CCD (19) est conçu comme un équivalent pour la position de foyer actuelle,
- les valeurs de contraste spécifiques à la position étant déterminées à partir de respectivement la différence entre une valeur d'intensité $I(x_i)$, qui est associée à une position i sur la ligne CCD (19), et une valeur d'intensité $I(x_{i+n})$, qui est associée à une position i+n voisine, et
- la position de l'élément principal de contraste sur le dispositif de réception étant déterminée pour toutes les valeurs de contraste $I(y_i)$, qui sont supérieures à une valeur moyenne $I_{min}$ prédéfinie.

**13.** Agencement selon la revendication 12, **caractérisé en ce que**

- l'ouverture de fente (14) est positionnée conjointement avec une ouverture de diaphragme (12), qui définit l'étendue et le grandeur d'un segment d'image sur l'échantillon (4), dans un plan d'obturateur de zone (10),
- l'ouverture de diaphragme (12) étant axée de façon centrée par rapport à l'axe optique (2) de la trajectoire du faisceau d'éclairage et l'ouverture de fente (14) se trouvant sur la périphérie de la trajectoire du faisceau d'éclairage.

**14.** Agencement selon la revendication 13, **caractérisé en ce que**

- l'ouverture de diaphragme (12) est orientée perpendiculairement à l'axe optique (2) de la trajectoire du faisceau d'éclairage,
- l'ouverture de fente (14) forme avec l'axe optique (2) un angle qui correspond à l'angle duquel la ligne CCD (19) est inclinée par rapport à l'axe (33) optique de la trajectoire du faisceau de détection,

- la longueur de course optique entre l'échantillon (4) et l'ouverture de fente (14) est aussi longue que la longueur de course optique entre l'échantillon (4) et la ligne CCD (19).

**15.** Agencement selon l'une quelconque des revendications 12 à 14, **caractérisé en ce que** le dispositif d'analyse (21) comprend :

- un soustracteur, qui détermine des valeurs de contraste $I(y_i)$ spécifiques à la position selon la fonction

$$\forall i \;\; I(yi) = \left| I(x_i) - I(x_{i+n}) \right|$$

avec les valeurs d'intensité $I(x_i)$ et $I(x_{i+n})$, les positions i sur le dispositif de réception et avec n=1...20, et

- un circuit de calcul, qui détermine l'élément principal de contraste comme équivalent pour la position de foyer actuelle selon la fonction

$$P_f = \frac{\sum_i y_i . I(y_i)}{\sum_i I(y_i)}$$

pour toutes les valeurs de contraste $I(y_i)$ qui sont supérieures à une valeur minimale $I_{min}$ prédéfinie.

**16.** Agencement selon l'une quelconque des revendications 12 à 15, **caractérisé en ce**

- **qu'**un circuit de calcul est prévu dans le dispositif d'analyse pour la détermination de la distance b entre le lieu $P_f$ et un lieu $P_f''$, qui correspond à la position de foyer idéale sur la ligne CCD (19), et
- le dispositif d'analyse (21) est en liaison avec un dispositif d'avance (22) pour la variation de la distance $\Delta z$ entre l'échantillon (4) et l'optique de reproduction.

**17.** Agencement selon l'une quelconque des revendications 12 à 16, **caractérisé en ce que** la fréquence de la grille est adaptée à la limite de résolution optique de l'optique de reproduction, à chaque fois de préférence cinq pixels (20) de la ligne CCD (19) correspondant à une période de grille.

EP 1 618 426 B1

Δz

9

7

4    3    8

5

6

16

33    19

18

17

10

14

2    12

11

1

Fig.1

18

14   15

13

2

11   12

Fig.2

19   20

i = 1                    x                    i = 2400

Fig.3

Fig. 4

EP 1 618 426 B1

Fig.5

EP 1 618 426 B1

Fig.6

Fig.7

Fig.8

EP 1 618 426 B1

Fig.9

Fig.10

Fig.11

EP 1 618 426 B1

Fig.12

EP 1 618 426 B1

$$Y2 = m2 * X2 + n2$$

$$Y1 = m1 * X1 + n1$$

Fig.13